# EUROPEAN PATENT APPLICATION

(11) **EP 4 246 575 A2**
(43) Date of publication of application: **20.09.2023**
(21) Application number: 23161788.7
(22) Date of filing: 14.03.2023
(51) Int. Cl.: H01L 25/075, G09G 3/3233

(54) **DISPLAY DEVICE**

(30) Priority: 14.03.2022 KR 20220031569
(71) Applicant: Samsung Display Co., Ltd., Yongin-si, Gyeonggi-do 17113 (KR)
(72) Inventor: PARK, Do Yeong, 17113 Yongin-si (KR); KIM, Kyung Bae, 17113 Yongin-si (KR); CHAI, Chong Chul, 17113 Yongin-si (KR)
(74) Representative: Walaski, Jan Filip

(57) **Abstract**

A display device includes first, second, and third pixels adjacent to each other. Each of the first, second, and third pixels includes: light emitting elements; connection electrodes electrically connected to ends of the light emitting elements; and sub-electrodes on a same layer as the connection electrodes and electrically connected to the connection electrodes, and one of the sub-electrodes of the first pixel is electrically connected to one of the sub-electrodes of the second pixel.

## Description

### BACKGROUND

### 1. Field

The present disclosure relate to a display device.

### 2. Description of Related Art

Recently, as interest in information display continues to increase, research and development into display devices has been continuously conducted.

### SUMMARY

Embodiments of the present disclosure are directed to a high resolution display device without (or minimizing) a dark spot defect of a pixel.

Aspects and features of the present disclosure are not limited to those described above, and those skilled in the art will clearly understand aspects and features from the accompanying detailed description and claims.

A display device in accordance with an embodiment includes first, second, and third pixels adjacent to each other, and each of the first, second, and third pixels includes: light emitting elements; connection electrodes electrically connected to ends of the light emitting elements; and sub-electrodes on a same layer as the connection electrodes and electrically connected to the connection electrodes. One of the sub-electrodes of the first pixel is electrically connected to one of the sub-electrodes of the second pixel.

The sub-electrode of the first pixel and the sub-electrode of the second pixel that are electrically connected to each other may be on the same layer.

The display device may further include an intermediate electrode connecting the sub-electrode of the first pixel and the sub-electrode of the second pixel that are electrically connected to each other.

The sub-electrodes of the third pixel may be separated from the sub-electrodes of the first pixel and/or the sub-electrodes of the second pixel.

One of the sub-electrodes of the third pixel may be electrically connected to one of the sub-electrodes of the first pixel.

The connection electrodes may respectively include: a first connection electrode electrically connected to a first end of each of the light emitting elements; and a second connection electrode electrically connected to a second end of each of the light emitting elements. The first connection electrode and the second connection electrode may be on different layers.

The sub-electrodes may respectively include: a first sub-electrode on the same layer as the first connection electrode and electrically connected to the first connection electrode; and a second sub-electrode on the same layer as the second connection electrode and electrically connected to the second connection electrode.

The second sub-electrode of the first pixel may be electrically connected to the second sub-electrode of the second pixel.

The display device may further include: a first color conversion layer in the first pixel; a second color conversion layer in the second pixel; and a light scattering layer in the third pixel.

The display device may further include: a first color filter on the first color conversion layer in the first pixel; a second color filter on the second color conversion layer in the second pixel; and a third color filter on the light scattering layer in the third pixel.

A display device in accordance with an embodiment includes: first, second, and third pixels adjacent to each other; light emitting elements in the first, second, and third pixels; connection electrodes electrically connected to ends of the light emitting elements; sub-electrodes spaced apart from the connection electrodes; a first connector connecting first ends of the sub-electrodes to the respective connection electrodes; and a second connector connecting second ends of the sub-electrodes to the respective connection electrodes. One of the sub-electrodes of the first pixel is electrically connected to one of the sub-electrodes of the second pixel.

The first connector and/or the second connector may extend in a first direction between the connection electrodes and the sub-electrodes.

The sub-electrodes may extend in a second direction crossing the first direction.

The sub-electrodes may be on the same layer as the first connector and/or the second connector.

The first connector and the second connector may be on the same layer.

The connection electrodes may include: a first connection electrode electrically connected to a first end of each of the light emitting elements; and a second connection electrode electrically connected to a second end of each of the light emitting elements. The first connection electrode and the second connection electrode may be on different layers.

The sub-electrodes may include: a first sub-electrode on the same layer as the first connection electrode and electrically connected to the first connection electrode; and a second sub-electrode on the same layer as the second connection electrode and electrically connected to the second connection electrode.

The second sub-electrode of the first pixel may be electrically connected to the second sub-electrode of the second pixel.

The display device may further include an intermediate electrode connecting the second sub-electrode of the first pixel and the second sub-electrode of the second pixel.

The intermediate electrode may be on the same layer as the second sub-electrode of the first pixel and/or the second sub-electrode of the second pixel.

Further details of embodiments of the present disclosure are included in the detailed description and drawings.

### BRIEF DESCRIPTION OF THE DRAWINGS

FIG. 1 is a perspective view of a light emitting element in accordance with an embodiment.
FIG. 2 is a sectional view of the light emitting element shown in FIG. **1****.**
FIG. 3 is a plan view of a display device in accordance with an embodiment.
FIG. 4 is a circuit diagram of a sub-pixel in accordance with an embodiment.
FIG. 5 is a plan view of a pixel circuit area of a pixel in accordance with an embodiment.
FIG. 6 is a plan view of an emission area of the pixel shown in FIG. 5 in accordance with an embodiment.
FIG. 7 is a plan view of a sub-pixel in accordance with an embodiment.
FIG. 8 is a plan view showing a connection relationship between sub-electrodes of sub-pixels in accordance with an embodiment.
FIG. 9 is a plan view showing a connection relationship between sub-electrodes of sub-pixels in accordance with an embodiment.
FIG. 10 is a sectional view taken along the line A-A' of FIG. 7.
FIG. 11 is a sectional view of first to third sub-pixels in accordance with an embodiment.
FIG. 12 is a plan view showing a connection relationship between sub-electrodes of sub-pixels in accordance with an embodiment.
FIG. 13 is a plan view showing a connection relationship between sub-electrodes of sub-pixels in accordance with an embodiment.
FIG. 14 is a plan view showing a connection relationship between sub-electrodes of sub-pixels in accordance with an embodiment.

### DETAILED DESCRIPTION

Aspects and features of the present disclosure, and methods for achieving the same, will be described with reference to embodiments together with the accompanying drawings. The present disclosure is not limited to the described embodiments, however, and various modifications are possible. These embodiments are provided so that this disclosure will be thorough and complete and will fully convey the concept of the present disclosure to those skilled in the art, and the present disclosure is to be defined by the appended claims and their equivalents.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof. It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

It will be understood that, although the terms "first", "second", etc. may be used herein to describe various elements, these elements should not be limited by these terms. These terms are only used to distinguish one element from another element. For instance, a first element discussed below could be termed a second element without departing from the teachings of the present disclosure.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of," when preceding a list of elements, modify the entire list of elements and do not modify the individual elements of the list. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

Hereinafter, embodiments of the present disclosure will be described, in detail, with reference to the accompanying drawings.

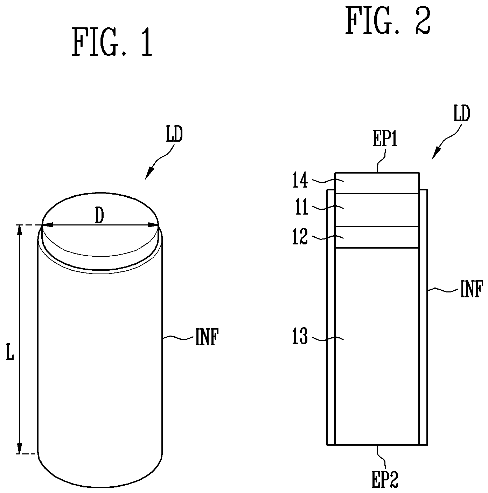

FIG. 1 is a perspective view of a light emitting element LD in accordance with an embodiment, and FIG. 2 is a sectional view of the light emitting element LD shown in FIG. **1****.** Although FIGS. 1 and 2 illustrate a column-type light emitting element LD, the type and/or shape of the light emitting element LD is not limited thereto.

Referring to FIGS. 1 and 2, the light emitting element LD may include a first semiconductor layer 11, an active layer 12, a second semiconductor layer 13, and/or an electrode layer 14.

The light emitting element LD may be provided in the form of (or shape of) a column extending in (or extending primarily in) one direction. The light emitting element LD may have a first end EP1 and a second end EP2. One of the first and second semiconductor layers 11 and 13 may be disposed at the first end EP1 of the light emitting element LD, and the other one of the first and second semiconductor layers 11 and 13 may be disposed at the second end EP2 of the light emitting element LD. For example, the first semiconductor layer 11 may be disposed at the first end EP1 of the light emitting element LD, and the second semiconductor layer 13 may be disposed at the second end EP2 of the light emitting element LD.

In an embodiment, the light emitting element LD may be a light emitting element fabricated in a column shape by an etching scheme (or method) or the like. In the present specification, the term "column-type" embraces a rod-like shape and a bar-like shape, such as a cylindrical shape and a prismatic shape having an aspect ratio greater than 1, and the cross-sectional shape thereof is not limited.

The light emitting element LD may have a small size corresponding to a range from the nanometer scale to the micrometer scale. For example, the light emitting element LD may have a diameter (or a width) D and/or a length L ranging from the nanometer scale to the micrometer scale. However, the size of the light emitting element LD is not limited thereto, and the size of the light emitting element LD may be variously modified depending on design conditions of various devices, such as a display device using a light emitting device with the light emitting element LD as a light source.

The first semiconductor layer 11 may be a first conductive semiconductor layer. For example, the first semiconductor layer 11 may include a p-type semiconductor layer. For instance, the first semiconductor layer 11 may include a p-type semiconductor layer, which includes any one semiconductor material of InAlGaN, GaN, AlGaN, InGaN, or AlN and is doped with a first conductive dopant, such as Mg. However, the material for forming the first semiconductor layer 11 is not limited thereto, and the first semiconductor layer 11 may be formed of various other materials.

The active layer 12 may be disposed between the first semiconductor layer 11 and the second semiconductor layer 13. The active layer 12 may include any one structure of a single well structure, a multi-well structure, a single-quantum well structure, a multi-quantum well (MQW) structure, a quantum dot structure, and a quantum line structure, but the present disclosure is not limited thereto. The active layer 12 may include GaN, InGaN, InAlGaN, AlGaN, or AlN. In addition, various other materials may be used to form the active layer 12.

When a voltage equal to or greater than a threshold voltage is applied between the opposite ends EP1/EP2 of the light emitting element LD, the light emitting element LD may emit light by the coupling of electron-hole pairs in the active layer 12. Because light emission of the light emitting element LD can be controlled based on the foregoing principle, the light emitting element LD may be used as a light source of various light emitting devices as well as a pixel of the display device.

The second semiconductor layer 13 may be disposed on the active layer 12 and may include a semiconductor layer of a type different from that of the first semiconductor layer 11. The second semiconductor layer 13 may include an n-type semiconductor layer. For instance, the second semiconductor layer 13 may include an n-type semiconductor layer, which includes any one semiconductor material of InAlGaN, GaN, AlGaN, InGaN, and AlN and is doped with a second conductive dopant, such as Si, Ge, or Sn. However, the material for forming the second semiconductor layer 13 is not limited thereto, and the second semiconductor layer 13 may be formed of various other materials.

The electrode layer 14 may be disposed at the first end EP1 and/or the second end EP2 of the light emitting element LD. Although FIG. 2 illustrates an embodiment in which the electrode layer 14 is formed on the first semiconductor layer 11, the present disclosure is not limited thereto. For example, a separate electrode layer may be further disposed on the second semiconductor layer 13.

The electrode layer 14 may include transparent metal or transparent metal oxide. For example, the electrode layer 14 may include at least one of indium tin oxide (ITO), indium zinc oxide (IZO), and zinc tin oxide (ZTO), but the present disclosure is not limited thereto. In an embodiment in which the electrode layer 14 is formed of transparent metal or transparent metal oxide, light generated from (or in) the active layer 12 of the light emitting element LD may be emitted from the light emitting element LD through the electrode layer 14.

An insulating layer INF may be provided on a surface of the light emitting element LD. The insulating layer INF may be directly disposed on a surface of the first semiconductor layer 11, a surface of the active layer 12, a surface of the second semiconductor layer 13, and/or a surface of the electrode layer 14. The first and second ends EP1 and EP2 of the light emitting element LD that have different polarities may be exposed through the insulating layer INF. In an embodiment, a sidewall of the electrode layer 14 and/or the second semiconductor layer 13 (or a portion thereof) disposed adjacent to the first and second ends EP1 and EP2 of the light emitting element LD may be exposed through the insulating layer INF.

The insulating layer INF may prevent the active layer 12 from short-circuiting due to contacting a conductive material other than the first and second semiconductor layers 11 and 13. Furthermore, the insulating layer INF may reduce or minimize a surface defect of the light emitting elements LD, thereby enhancing the lifetime and emission efficiency of the light emitting elements LD.

The insulating film INF may include at least one of silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium dioxide (TiOₓ). For example, the insulating layer INF may have a double layer structure, and respective layers that form the double layer structure may include different materials. For example, the insulating layer INF may have a double layer structure formed of aluminum oxide (AlOₓ) and silicon oxide (SiOₓ), but the present disclosure is not limited thereto. In an embodiment, the insulating layer INF may be omitted.

A light emitting device including the light emitting element LD described above may be used not only in a display device but also in various devices which employ (or need) a light source. For instance, light emitting elements LD may be disposed in each pixel of a display panel so that the light emitting elements LD may be used as a light source of the pixel. However, the application field of the light emitting element LD is not limited to the above-mentioned examples. For example, the light emitting element LD may also be used in other types of devices, such as a lighting device that uses a light source.

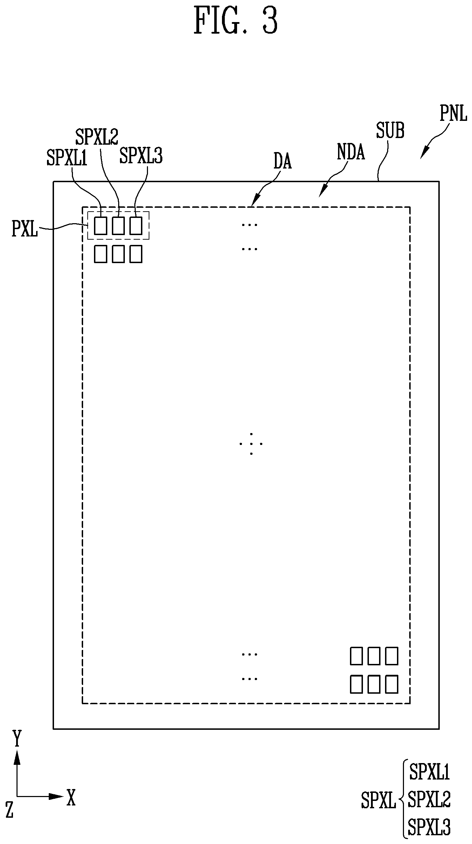

FIG. 3 is a plan view of a display device in accordance with an embodiment.

FIG. 3 illustrates a display device, particularly, a display panel PNL provided in the display device, as an example of an electronic device which may use, as a light source, the light emitting element LD described, as an example, with respect to FIGS. 1 and 2.

Each pixel PXL of the display panel PNL and each sub-pixel SPXL of the pixel PXL may include at least one light emitting element LD. For the sake of explanation, FIG. 3 simply illustrates the structure of the display panel PNL in accordance with an embodiment, focused on a display area DA. In some embodiments, at least one driving circuit (e.g., at least one of a scan driver and a data driver), lines, and/or pads may be further provided on the display panel PNL.

Referring to FIG. 3, the display panel PNL may include a substrate SUB and pixels PXL disposed on the substrate SUB. The pixels PXL each may include a first sub-pixel SPXL1, a second sub-pixel SPXL2, and/or a third sub-pixel SPXL3. Hereinafter, the term "sub-pixel SPXL" or "sub-pixels SPXL" will be used to arbitrarily designate any one sub-pixel from among the first sub-pixel SPXL1, the second sub-pixel SPXL2, and the third sub-pixel SPXL3, or to collectively designate two or more of the sub-pixels.

The substrate SUB may form a base of the display panel PNL and may be a rigid or flexible substrate or film. For example, the substrate SUB may be a rigid substrate made of glass or reinforced glass or a flexible substrate (or a thin film) formed of plastic or metal, but the material and/or properties of the substrate SUB are not particularly limited.

The display panel PNL and the substrate SUB for forming the display panel PNL may have a display area DA for displaying an image and a non-display area NDA other than (e.g., around) the display area DA. The pixels PXL may be disposed in the display area DA. Various lines, pads, and/or internal circuits that are connected to the pixels PXL of the display area DA may be disposed in the non-display area NDA. The pixels PXL may be regularly arranged according to a stripe or PENTILE^{®} (a registered trademark of Samsung Display Co., Ltd.) (e.g., an RGBG matrix) arrangement structure. The arrangement structure of the pixels PXL is not limited thereto, and the pixels PXL may be arranged in the display area DA in various structures and/or schemes.

In an embodiment, the pixels PXL each may include two or more types of sub-pixels SPXL that may emit different color light. For example, first sub-pixels SPXL1 configured to emit a first color of light, second sub-pixels SPXL2 configured to emit a second color of light, and third sub-pixels SPXL3 configured to emit a third color of light may be arranged in the display area DA. At least one first sub-pixel SPXL1, at least one second sub-pixel SPXL2, and at least one third sub-pixel SPXL3 that are disposed adjacent to each other may form one pixel PXL to emit various colors of light. For example, the first sub-pixel SPXL1 may be a red pixel configured to emit red light, the second sub-pixel SPXL2 may be a green pixel configured to emit green light, and the third sub-pixel SPXL3 may be a blue pixel configured to emit blue light. However, the present disclosure is not limited thereto.

In an embodiment, the first sub-pixel SPXL1, the second sub-pixel SPXL2, and the third sub-pixel SPXL3 may respectively include light emitting elements configured to emit the same color of light and color conversion layers and/or color filters pertaining to different colors may be disposed on the respective light emitting elements so that the first, second, and third sub-pixels SPXL1, SPXL2, and SPXL3 may respectively emit the first color of light, the second color of light, and the third color of light. In an embodiment, the first sub-pixel SPXL1, the second sub-pixel SPXL2, and the third sub-pixel SPXL3 may respectively include, as light sources, a light emitting element related to (or configured to emit) the first color, a light emitting element related to (or configured to emit) the second color, and a light emitting element related to (or configured to emit) the third color, so that the first, second, and third sub-pixels SPXL1, SPXL2, and SPXL3 may respectively emit the first color of light, the second color of light, and the third color of light. However, the colors, the types, and/or the number of sub-pixels SPXL that form each pixel PXL are not particularly limited.

Each of the sub-pixels SPXL may include at least one light source which is driven by a certain control signal (e.g., a scan signal and a data signal) and/or a certain power supply (e.g., a first driving power supply and a second driving power supply). In an embodiment, the light source may include at least one light emitting element LD, such as in accordance with the embodiment described with respect to FIGS. 1 and 2 (e.g., subminiature column-type light emitting elements LD having a small size corresponding to a range from the nanometer scale to the micrometer scale). However, the present disclosure is not limited thereto, and different types of light emitting elements LD may be used as a light source of the sub-pixel SPXL.

In an embodiment, each sub-pixel SPXL may be an active pixel. However, the types, structures, and/or driving schemes of the sub-pixels SPXL applicable to the display device are not particularly limited. For example, each sub-pixel SPXL may be formed of a pixel for passive or active light emitting display devices, which have various structures and/or may be operated in various driving schemes.

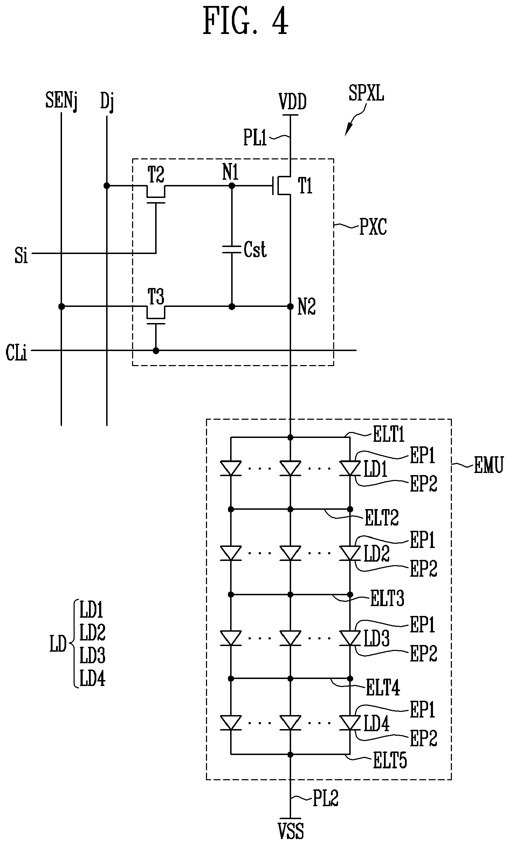

FIG. 4 is a circuit diagram of a sub-pixel in accordance with an embodiment.

FIG. 4 illustrates an electrical connection relationship of components included in each of the first to third sub-pixels SPXL1, SPXL2, and SPXL3 shown in FIG. 3, but the components included in each of the first to third sub-pixels SPXL1, SPXL2, and SPXL3 are not limited thereto. Furthermore, in FIG. 4, the term "sub-pixel SPXL" may embrace not only the components included in each of the first to third sub-pixels SPXL1, SPXL2, and SPXL3 but also an area where the components are provided.

Referring to FIG. 4, each of the first to third sub-pixels SPXL1, SPXL2, and SPXL3 may include an emission component (or an emission unit) EMU configured to generate light having a luminance corresponding to a data signal. Furthermore, the sub-pixel SPXL may further include a pixel circuit PXC configured to drive the emission component EMU.

For example, the emission component EMU may include a first connection electrode ELT1 connected to a first driving power supply VDD via the pixel circuit PXC and a first power line PL1, a fifth connection electrode ELT5 connected to a second driving power supply VSS via the second power line PL2, and a plurality of light emitting elements LD connected between the first and fifth connection electrodes ELT1 and ELT5. The first driving power supply VDD and the second driving power supply VSS may have different potentials to allow the light emitting elements LD to emit light. For example, the first driving power supply VDD may be set as a high-potential power supply, and the second driving power supply VSS may be set as a low-potential power supply.

In an embodiment, the emission component EMU may include at least one serial stage. Each serial stage may include a pair of electrodes (e.g., two electrodes) and at least one light emitting element LD connected in a forward direction between the pair of electrodes. The number of serial stages that form the emission component EMU and the number of light emitting elements LD that form each serial stage are not particularly limited. For example, the numbers of light emitting elements LD that form the respective serial stages may be identical with or different from each other. The number of light emitting elements LD of each serial stage is not particularly limited.

For example, the emission component EMU may include a first serial stage including at least one first light emitting element LD1, a second serial stage including at least one second light emitting element LD2, a third serial stage including at least one third light emitting element LD3, and a fourth serial stage including at least one fourth light emitting element LD4.

The first serial stage may include the first connection electrode ELT1, a second connection electrode ELT2, and at least one first light emitting element LD1 connected between the first and second connection electrodes ELT1 and ELT2. Each first light emitting element LD1 may be connected in the forward direction between the first and second connection electrodes ELT1 and ELT2. For example, a first end EP1 of the first light emitting element LD1 may be connected to the first connection electrode ELT1. A second end EP2 of the first light emitting element LD1 may be connected to the second connection electrode ELT2.

The second serial stage may include the second connection electrode ELT2, a third connection electrode ELT3, and at least one second light emitting element LD2 connected between the second and third connection electrodes ELT2 and ELT3. Each second light emitting element LD2 may be connected in the forward direction between the second and third connection electrodes ELT2 and ELT3. For example, a first end EP1 of the second light emitting element LD2 may be connected to the second connection electrode ELT2. A second end EP2 of the second light emitting element LD2 may be connected to the third connection electrode ELT3.

The third serial stage may include the third connection electrode ELT3, a fourth connection electrode ELT4, and at least one third light emitting element LD3 connected between the third and fourth connection electrodes ELT3 and ELT4. Each third light emitting element LD3 may be connected in the forward direction between the third and fourth connection electrodes ELT3 and ELT4. For example, a first end EP1 of the third light emitting element LD3 may be connected to the third connection electrode ELT3. A second end EP2 of the third light emitting element LD3 may be connected to the fourth connection electrode ELT4.

The fourth serial stage may include the fourth connection electrode ELT4, the fifth connection electrode ELT5, and at least one fourth light emitting element LD4 connected between the fourth and fifth connection electrodes ELT4 and ELT5. Each fourth light emitting element LD4 may be connected in the forward direction between the fourth and fifth connection electrodes ELT4 and ELT5. For example, a first end EP1 of the fourth light emitting element LD4 may be connected to the fourth connection electrode ELT4. A second end EP2 of the fourth light emitting element LD4 may be connected to the fifth connection electrode ELT5.

The first electrode of the emission component EMU (e.g., the first connection electrode ELT1) may be an anode electrode of the emission component EMU. The last electrode of the emission component EMU (e.g., the fifth connection electrode ELT5) may be a cathode electrode of the emission component EMU.

In an embodiment in which the light emitting elements LD are connected in a serial/parallel structure, power efficiency may be enhanced compared to an embodiment in which an equal number of light emitting elements LD are connected to each other only in parallel. Furthermore, in the sub-pixel SPXL in which the light emitting elements LD are connected in the serial/parallel structure, even if a short-circuit defect or the like occurs in some serial stages, sufficient luminance can be expressed by the light emitting elements LD of the other serial stages so that the probability of a black spot defect occurring in the sub-pixel SPXL can be reduced. However, the present disclosure is not limited thereto. The emission component EMU may be formed by connecting the light emitting elements LD only in series. In other embodiments, the emission component EMU may be formed by connecting the light emitting elements LD only in parallel.

Each of the light emitting elements LD may have a first end EP1 (e.g., a p-type end) connected to the first driving power supply VDD via at least one electrode (e.g., the first connection electrode ELT1), the pixel circuit PXC, the first power line PL1, and/or the like, and a second end EP2 (e.g., an n-type end) connected to the second driving power supply VSS via at least another electrode (e.g., the fifth connection electrode ELT5), the second power line PL2, and the like. For example, the light emitting elements LD may be connected in the forward direction between the first driving power supply VDD and the second driving power supply VSS. The light emitting elements LD connected in the forward direction may form valid (e.g., operable or functioning) light sources of the emission component EMU.

The light emitting elements LD may emit, when driving current is supplied thereto through the corresponding pixel circuit PXC, light having luminance corresponding to the driving current. For example, during each frame period, the pixel circuit PXC may supply driving current corresponding to a gray scale value to be expressed in the corresponding frame to the emission component EMU. Hence, the light emitting elements LD may emit light having luminance corresponding to the driving current so that the emission component EMU may express the luminance corresponding to the driving current.

The light emitting elements LD of the emission component EMU may emit light having a luminance corresponding to driving current supplied thereto through the pixel circuit PXC. For example, during each frame period, the pixel circuit PXC may supply, to the emission component EMU, driving current corresponding to a gray scale value of corresponding frame data. The driving current supplied to the emission component EMU may be divided into parts which flow into the respective light emitting elements LD. Hence, each of the light emitting elements LD may emit light having a luminance corresponding to current applied thereto so that the light emitter EMU may emit light having a luminance corresponding to the driving current.

The pixel circuit PXC may be connected to a scan line Si and a data line Dj of the corresponding sub-pixel SPXL. For example, when the sub-pixel SPXL is disposed on an i-th row and a j-th column of the display area DA, the pixel circuit PXC of the sub-pixel SPXL may be connected to an i-th scan line Si and a j-th data line Dj of the display area DA. Furthermore, the pixel circuit PXC may be connected to an i-th control line CLi and a j-th sensing line SENj of the display area DA.

The pixel circuit PXC may include first to third transistors T1, T2, and T3, and a storage capacitor Cst.

The first transistor T1 may be a driving transistor configured to control driving current to be applied to the emission component EMU and connected between the first driving power supply VDD and the emission component EMU. In detail, a first terminal of the first transistor T1 may be connected (or coupled) to the first driving power supply VDD via the first power line PL1. A second terminal of the first transistor T1 may be connected to a second node N2. A gate electrode of the first transistor T1 may be connected to a first node N1. The first transistor T1 may control, in response to a voltage applied to the first node N1, the amount of driving current to be applied from the first driving power supply VDD to the emission component EMU through the second node N2. In an embodiment, the first terminal of the first transistor T1 may be a drain electrode, and the second terminal of the first transistor T1 may be a source electrode, and the present disclosure is not limited thereto. In an embodiment, the first terminal may be a source electrode, and the second terminal may be a drain electrode.

The second transistor T2 may be a switching transistor configured to select a sub-pixel SPXL in response to a scan signal and activate the sub-pixel SPXL and may be connected between the data line Dj and the first node N1. A first terminal of the second transistor T2 may be connected to the data line Dj. A second terminal of the second transistor T2 may be connected to the first node N1. A gate electrode of the second transistor T2 may be connected to the scan line Si. The first terminal and the second terminal of the second transistor T2 are different terminals, and, for example, if the first terminal is a drain electrode, and the second terminal may be a source electrode.

When a scan signal having a gate-on voltage (e.g., a high level voltage) is supplied from the scan line Si, the second transistor T2 may be turned on to electrically connect the data line Dj with the first node N1. The first node N1 may be a point at which the second terminal of the second transistor T2 and the gate electrode of the first transistor T1 are connected to each other. The second transistor T2 may transmit a data signal to the gate electrode of the first transistor T1.

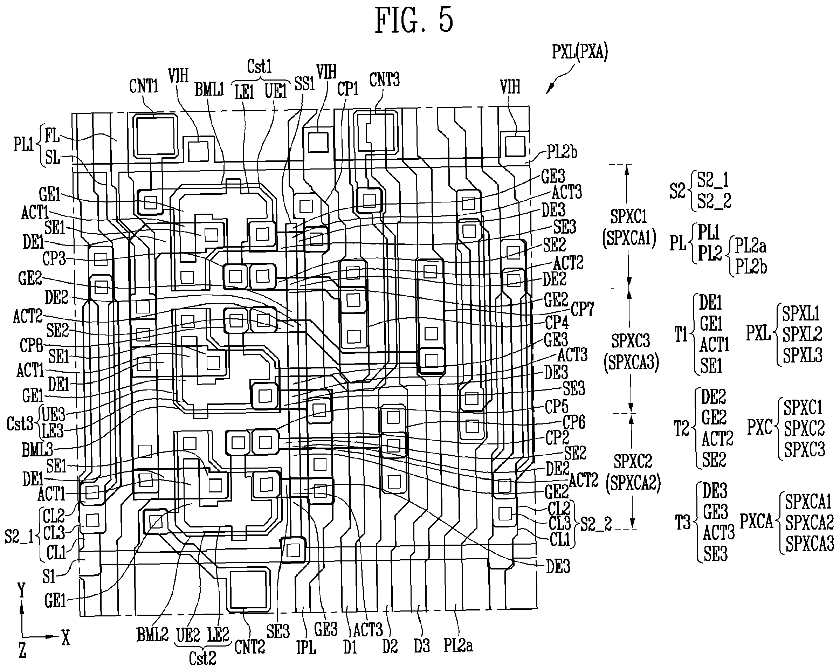

The third transistor T3 may obtain a sensing signal through the sensing line SENj by connecting the first transistor T1 to the sensing line SENj, and may detect, using the sensing signal, characteristics of the pixel SPXL, such as a threshold voltage of the first transistor T1. Information about the characteristics of each sub-pixel SPXL may be used to convert image data to compensate for characteristic deviation between sub-pixels SPXL. A second terminal of the third transistor T3 may be connected to the second terminal of the first transistor T1. A first terminal of the third transistor T3 may be connected to the sensing line SENj. A gate electrode of the third transistor T3 may be connected to the control line CLi. However, the present disclosure is not limited thereto. As illustrated in FIG. 5, a gate electrode (e.g., GE3 in FIG. 5) of the third transistor T3 and a gate electrode (e.g., GE2 in FIG. 5) of the second transistor T2 may be connected to an identical (e.g., the same) scan line (e.g., SS1 in FIG. 5).

Furthermore, the first terminal of the third transistor T3 may be connected to an initialization power supply. The third transistor T3 may be an initialization transistor configured to initialize the second node N2 and may be turned on when a sensing control signal is supplied thereto from the control line CLi so that a voltage of the initialization power supply can be transmitted to the second node N2. Hence, a second storage electrode (e.g., an upper electrode) of the storage capacitor Cst connected to the second node N2 may be initialized.

A first storage electrode of the storage capacitor Cst may be connected to the first node N1. A second storage electrode of the storage capacitor Cst may be connected to the second node N2. The storage capacitor Cst may be charged with a data voltage corresponding to a data signal to be supplied to the first node N1 during one frame period. Hence, the storage capacitor Cst may store a voltage corresponding to a difference between a voltage of the gate electrode of the first transistor T1 and a voltage of the second node N2.

Although FIG. 4 illustrates an embodiment in which all of the first to third transistors T1, T2, and T3 are N-type transistors, the present disclosure is not limited thereto. For example, at least one of the first to third transistors T1, T2, and T3 may be changed to a P-type transistor. Furthermore, although FIG. 4 illustrates an embodiment in which the emission component EMU is connected between the pixel circuit PXC and the second driving power supply VSS, the emission component EMU may be connected between the first driving power supply VDD and the pixel circuit PXC.

The structure of the pixel circuit PXC may be modified in various ways. For example, the pixel circuit PXC may further include at least one transistor element, such as a transistor element configured to initialize the first node N1 and/or a transistor element configured to control an emission time of the light emitting elements LD, or other circuit elements, such as a boosting capacitor configured to boost the voltage of the first node N1.

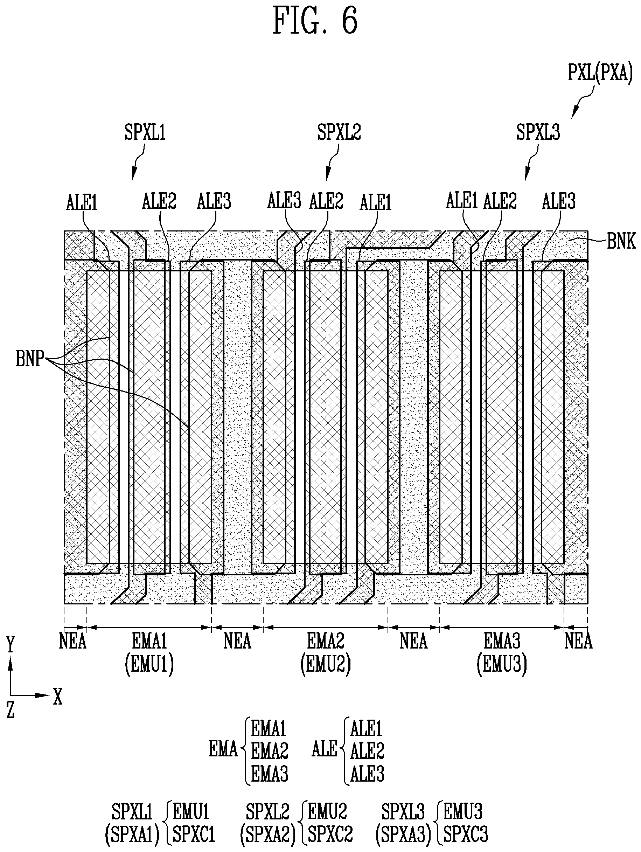

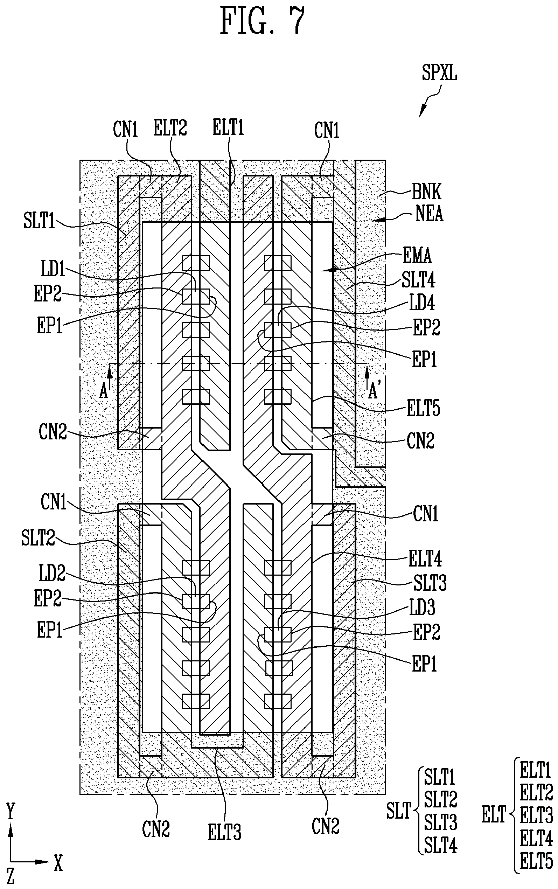

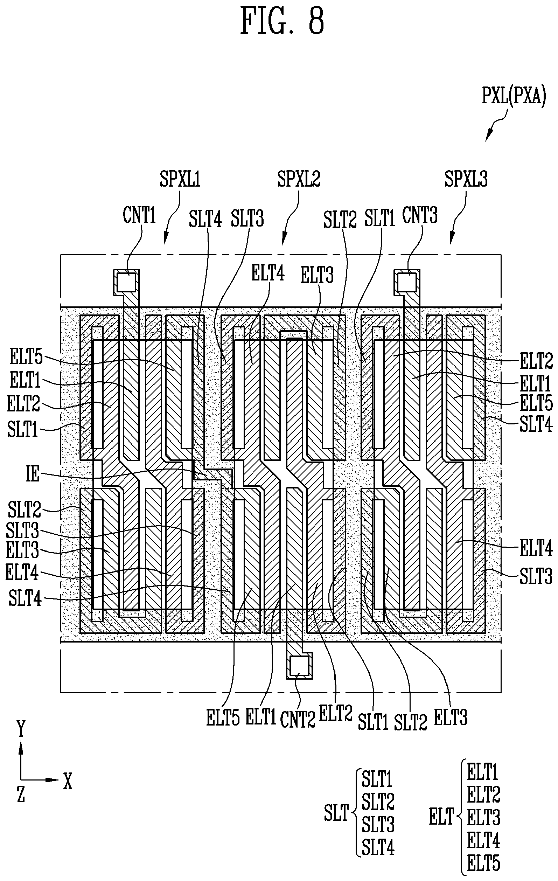

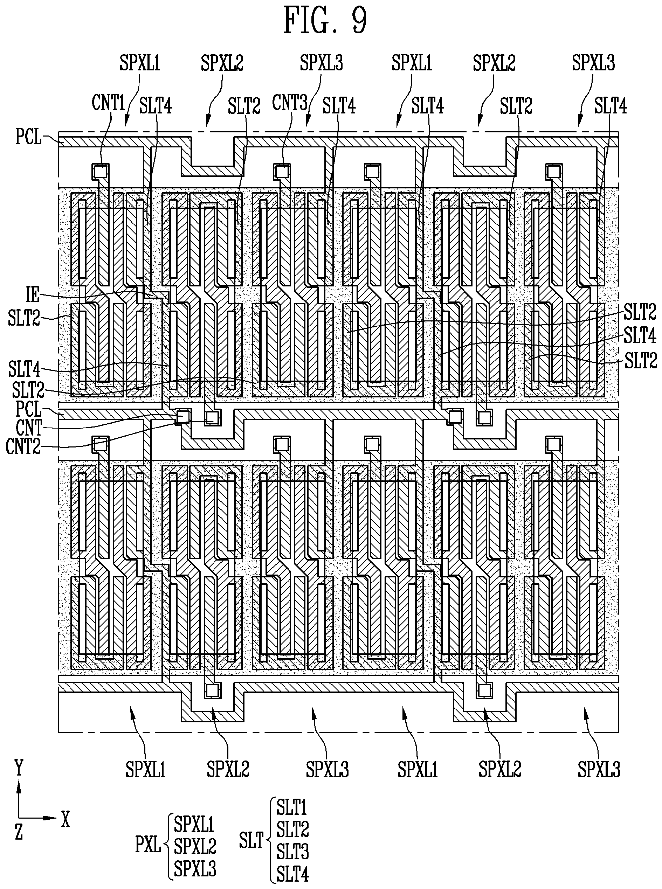

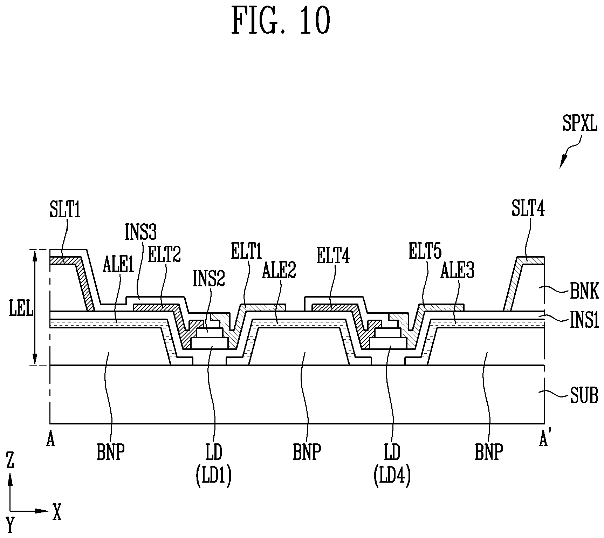

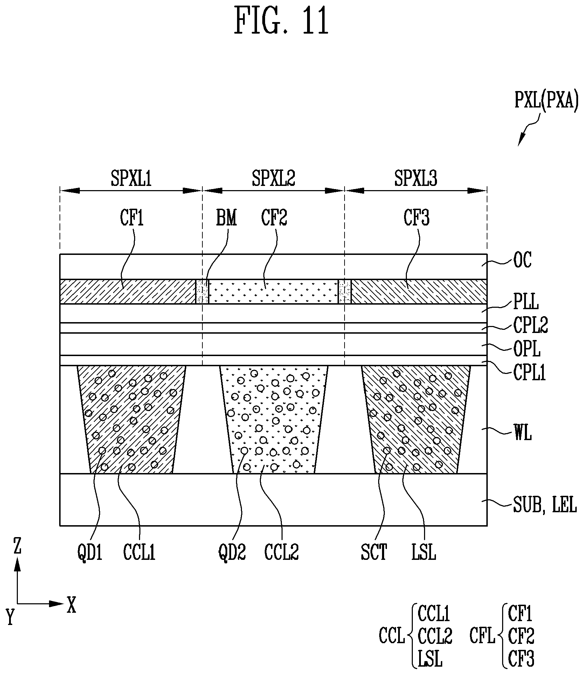

FIG. 5 is a plan view of a pixel circuit area of the pixel PXL in accordance with an embodiment. FIG. 6 is a plan view of an emission area of the pixel PXL in accordance with an embodiment. FIG. 7 is a plan view of a sub-pixel SPXL in accordance with an embodiment. FIG. 8 is a plan view showing a connection relationship between sub-electrodes SLT of sub-pixels SPXL in accordance with an embodiment. FIG. 9 is a plan view showing a connection relationship between sub-electrodes SLT of sub-pixels SPXL in accordance with an embodiment. FIG. 10 is a sectional view taken along the line A-A' of FIG. 7. FIG. 11 is a sectional view illustrating first to third sub-pixels SPXL1, SPXL2, and SPXL3 in accordance with an embodiment.

Referring to FIGS. 5 to 11, the pixel PXL may include a first sub-pixel SPXL1, a second sub-pixel SPXL2, and a third sub-pixel SPXL3.

The first sub-pixel SPXL1 may include a first pixel circuit SPXC1 and a first emission component EMU1. The second sub-pixel SPXL2 may include a second pixel circuit SPXC2 and a second emission component EMU2. The third sub-pixel SPXL3 may include a third pixel circuit SPXC3 and a third emission component EMU3.

The first pixel circuit SPXC1, the second pixel circuit SPXC2, and the third pixel circuit SPXC3 may form the pixel circuit PXC of the pixel PXL. The first emission component EMU1, the second emission component EMU2, and the third emission component EMU3 may form the emission component (e.g., EMU in FIG. 4) of the pixel PXL.

An area of the pixel area PXA of the pixel PXL in which the first sub-pixel SPXL1 is provided may be a first sub-pixel area SPXA1. An area of the pixel area PXA in which the second sub-pixel SPXL2 is provided may be a second sub-pixel area SPXA2. An area of the pixel area PXA in which the third sub-pixel SPXL3 is provided may be a third sub-pixel area SPXA3.

The pixel area PXA may include a first pixel circuit area SPXCA1, a second pixel circuit area SPXCA2, and a third pixel circuit area SPXCA3. The first pixel circuit area SPXCA1 may be an area in which the first pixel circuit SPXC1 is provided. The second pixel circuit area SPXCA2 may be an area in which the second pixel circuit SPXC2 is provided. The third pixel circuit area SPXCA3 may be an area in which the third pixel circuit SPXC3 is provided.

The pixel area PXA may include a first emission area EMA1, a second emission area EMA2, and a third emission area EMA3. For example, the pixel area PXA may include the first emission area EMA1, the second emission area EMA2, and the third emission area EMA3 that are partitioned from each other with respect to a first direction (e.g., an X-axis direction).

The first emission area EMA1 may be an area where light is emitted from the light emitting elements LD that are driven by the first pixel circuit SPXC1. The light emitting elements LD may be a component of the first emission component EMU1. In an embodiment, the first emission area EMA1 may be an emission area of the first sub-pixel SPXL1.

The second emission area EMA2 may be an area where light is emitted from the light emitting elements LD that are driven by the second pixel circuit SPXC2. The light emitting elements LD may be a component of the second emission component EMU2. In an embodiment, the second emission area EMA2 may be an emission area of the second sub-pixel SPXL2.

The third emission area EMA3 may be an area where light is emitted from the light emitting elements LD that are driven by the third pixel circuit SPXC3. The light emitting elements LD may be a component of the third emission component EMU3. In an embodiment, the third emission area EMA3 may be an emission area of the third sub-pixel SPXL3.

The first emission area EMA1, the second emission area EMA2, and the third emission area EMA3 may form the emission area EMA of the pixel PXL.

The pixel area PXA may include a non-emission area NEA which is adjacent to the first emission area EMA1 (or encloses or extends around the perimeter of the first emission area EMA1), a non-emission area NEA which is adj acent to the second emission area EMA2 (or encloses or extends around the perimeter of the second emission area EMA2), and a non-emission area NEA which is adjacent to the third emission area EMA3 (or encloses or extends around the perimeter of the third emission area EMA3).

The substrate SUB of the pixel PXL or the pixel area PXA may include a plurality of insulating layers and a plurality of conductive layers. The insulating layers may include, for example, a buffer layer, a gate insulating layer, an interlayer insulating layer, a passivation layer, and/or a via layer that are successively provided. The conductive layers may be provided and/or formed between the insulating layers. The conductive layers may include, for example, a first conductive layer, a second conductive layer provided on the gate insulating layer, a third conductive layer provided on the interlayer insulating layer, and/or a fourth conductive layer provided on the via layer. However, the insulating layers and the conductive layers of the substrate SUB are not limited to those of the foregoing embodiment. In some embodiments, except the insulating layers and the conductive layers, other insulating layers and other conductive layers may be provided on the substrate SUB.

The substrate SUB may include signal lines that are electrically connected to the pixel PXL. The signal lines may transmit certain signals (or certain voltages) to the pixel PXL. For example, the signal lines may include a first scan line S1, a second scan line S2, data lines D1, D2, and D3, a power line PL, and an initialization power line IPL.

A scan signal and a control signal may be selectively applied to the first scan line S1. The first scan line S1 may extend in the first direction (e.g., the X-axis direction). The first scan line S1 may correspond to the third conductive layer provided on the interlayer insulating layer. The third conductive layer may be formed of a single layer or multiple layers made of molybdenum (Mo), copper (Cu), aluminum (Al), chrome (Cr), gold (Au), silver (Ag), titanium (Ti), nickel (Ni), neodymium (Nd), indium (In), tin (Sn), and an oxide or alloy thereof.

The first scan line S1 may be disposed on a sub-scan line SS1 and connected to the sub-scan line SS1 through a contact hole (or contact opening). For example, the first scan line S1 may be electrically connected to the sub-scan line SS1 through a contact hole passing through the interlayer insulating layer.

The sub-scan line SS1 may extend in a second direction (e.g., a Y-axis direction). The sub-scan line SS1 may correspond to the second conductive layer provided and/or formed on the gate insulating layer. The second conductive layer may include the same material as that of the third conductive layer or may include one or more materials selected from among materials described as example constituent materials of the third conductive layer.

In an embodiment, the sub-scan line SS1 may be integrally provided with a second gate electrode GE2 of the second transistor T2 of each of the first to third pixel circuits SPXC1, SPXC2, and SPXC3. For example, a portion of the sub-scan line SS1 may be the second gate electrode GE2 of the second transistor T2 of each of the first to third pixel circuits SPXC1, SPXC2, and SPXC3. Hence, the sub-scan line SS1 may be connected to the second gate electrode GE2 of the second transistor T2 of each of the first to third pixel circuits SPXC1, SPXC2, and SPXC3.

Furthermore, the sub-scan line SS1 may be integrally provided with a third gate electrode GE3 of the third transistor T3 of each of the first to third pixel circuits SPXC1, SPXC2, and SPXC3. For example, another portion of the sub-scan line SS1 may be the third gate electrode GE3 of the third transistor T3 of each of the first to third pixel circuits SPXC1, SPXC2, and SPXC3. Hence, the sub-scan line SS1 may be connected to the third gate electrode GE3 of the third transistor T3 of each of the first to third pixel circuits SPXC1, SPXC2, and SPXC3.

As described above, because the sub-scan line SS1 is connected with the first scan line S1 through the corresponding contact hole, the first scan line S1 may be electrically connected with some components (e.g., the second and third transistors T2 and T3) of each of the first to third pixel circuits SPXC1, SPXC2, and SPXC3 by the sub-scan line SS1. In such an embodiment, the first scan line S1 may supply a scan signal to the second transistor T2 of each of the first to third pixel circuits SPXC1, SPXC2, and SPXC3 during a driving period of the light emitting elements LD and may supply a control signal to the third transistor T3 of each of the first to third pixel circuits SPXC1, SPXC2, and SPXC3 during a sensing period.

The sub-scan line SS1 may be a component provided in common to the first to third pixel circuits SPXC1, SPXC2, and SPXC3. For example, the first to third pixel circuits SPXC1, SPXC2, and SPXC3 may share one sub-scan line SS1.

The data lines D1, D2, and D3 may include a first data line D1, a second data line D2, and a third data line D3 that extend in the second direction (e.g., the Y-axis direction) and are spaced apart from each other in the first direction (e.g., the X-axis direction). A data signal may be applied to each of the first to third data lines D1, D2, and D3.

The first data line D1 may be electrically connected to the second transistor T2 of the first pixel circuit SPXC1. The second data line D2 may be electrically connected to the second transistor T2 of the second pixel circuit SPXC2. The third data line D3 may be electrically connected to the second transistor T2 of the third pixel circuit SPXC3. The first to third data lines D1, D2, and D3 may correspond to the first conductive layer. The first conductive layer may include the same material as that of the third conductive layer or may include one or more materials selected from among materials described as the example constituent materials of the third conductive layer.

The power line PL may include a first power line PL1 and a second power line PL2.

The voltage of the first driving power supply (e.g., VDD in FIG. 4) may be applied to the first power line PL1. The first power line PL1 may extend in the second direction (e.g., the Y-axis direction). In an embodiment, the first power line PL1 may include a first layer FL and a second layer SL. The first layer FL may correspond to the first conductive layer. The second layer SL may correspond to the third conductive layer provided and/or formed on the interlayer insulating layer. The first layer FL may be provided on the same layer as that of the first to third data lines D1, D2, and D3. The second layer SL may be provided on the same layer as that of the first scan line S1. The second layer SL may be electrically connected with the first layer FL through at least one or more contact holes (or contact openings). For example, the second layer SL may be electrically connected with the first layer FL through at least one or more contact holes that successively pass through the buffer layer, the gate insulating layer, and the interlayer insulating layer. The first power line PL1 may be implemented as a double layer structure including the first layer FL and the second layer SL so that line resistance can be reduced, and thus, signal distortion can be reduced. However, the present disclosure is not limited thereto, and the first power line PL1 may be implemented as a single layer structure or a multi-layer structure including three or more layers.

The voltage of the second driving power supply (e.g., VSS in FIG. 4) may be applied to the second power line PL2. The second power line PL2 may include a 2a-th power line PL2a and a 2b-th power line PL2b.

The 2a-th power line PL2a may extend in the second direction (e.g., the Y-axis direction). The 2a-th power line PL2a may be implemented as a single layer structure. The 2a-th power line PL2a may correspond to the first conductive layer. The 2a-th power line PL2a may be provided on the same layer as that of the first to third data lines D1, D2, and D3 and the first layer FL of the first power line PL1. The 2a-th power line PL2a may be spaced apart from the first to third data lines D1, D2, and D3 and the first power line PL1 in a plan view.

In the foregoing embodiment, the 2a-th power line PL2a is implemented as a signal layer structure, but the present disclosure is not limited thereto. In another embodiment, the 2a-th power line PL2a may be implemented as a double-layer structure in a manner similar to that of the first power line PL1. In other embodiments, the 2a-th power line PL2a may be implemented as a multi-layer structure having three or more layers.

The 2b-th power line PL2b may extend in the first direction (e.g., the X-axis direction). The 2b-th power line PL2b may be spaced apart from the first scan line S1 in a plan view. However, the position of the 2b-th power line PL2b is not limited thereto. The 2b-th power line PL2b may be implemented as a single layer structure. The 2b-th power line PL2b may correspond to the third conductive layer provided and/or formed on the interlayer insulating layer. The 2b-th power line PL2b may be provided on the same layer as that of the first scan line S1 and the second layer SL of the first power line PL1. The 2b-th power line PL2b may be electrically connected, through via holes (or openings) VIH, to at least one of the electrodes ALE of the first to third sub-pixel areas SPXA1, SPXA2, and SPXA3, which will be described below.

The 2a-th power line PL2a and the 2b-th power line PL2b may be electrically connected to each other through a contact hole (or contact opening). For example, the 2b-th power line PL2b may be electrically connected to the 2a-th power line PL2a through a contact hole that successively passes through the buffer layer, the gate insulating layer, and the interlayer insulating layer. The second power line PL2 including the 2a-th power line PL2a and the 2b-th power line PL2b that are connected to each other may have a mesh structure.

The second scan line S2 may extend in the second direction (e.g., the Y-axis direction) that crosses the first direction (e.g., the X-axis direction), that is, the direction in which the first scan line S1 extends. In the pixel PXL, the second scan line S2 may cross the first scan line S1 and at least partially overlap the first scan line S1. The second scan line S2 may be a signal line which may be selectively supplied with a scan signal and a control signal. For example, the second scan line S2 may be supplied with a scan signal during a driving period of the light emitting elements LD and may be supplied with a control signal during a certain sensing period.

In an embodiment, the second scan line S2 may include a 2-1-th scan line S2_1 and a 2-2-th scan line S2_2. The 2-1-th scan line S2_1 and the 2-2-th scan line S2_2 each may extend in the second direction (e.g., the Y-axis direction).

Each of the 2-1-th scan line S2_1 and the 2-2-th scan line S2_2 may be implemented as a triple-layer structure including a first conductive line CL1, a second conductive line CL2, and a third conductive line CL3. The conductive line CL1 may correspond to the first conductive layer. The second conductive line CL2 may correspond to the second conductive layer provided and/or formed on the gate insulating layer. The third conductive line CL3 may correspond to the third conductive layer provided and/or formed on the interlayer insulating layer.

The first conductive line CL1 may be provided on the same layer as that of the first to third data lines D1, D2, and D3, the first layer FL of the first power line PL1, and the 2a-th power line PL2a. The second conductive line CL2 may be provided on the same layer as that of the sub-scan line SS1. The third conductive line CL3 may be provided on the same layer as that of the first scan line S1 and the second layer SL of the first power line PL1. The third conductive line CL3 may be connected to the first conductive line CL1 and/or the second conductive line CL2 through a contact hole (or contact opening). For example, the third conductive line CL3 may be electrically connected with the first conductive line CL1 through a contact hole that successively passes through the buffer layer, the gate insulating layer, and the interlayer insulating layer. Furthermore, the third conductive line CL3 may be electrically connected with the second conductive line CL2 through a contact hole passing through the interlayer insulating layer. Hence, the first conductive line CL1 and the second conductive line CL2 may be connected to each other by the third conductive line CL3.

In an embodiment, the third conductive line CL3 may be provided and/or formed on the second conductive line CL2 with the interlayer insulating layer interposed therebetween. The second conductive line CL2 may be provided and/or formed on the first conductive line CL1 with the gate insulating layer and the buffer layer interposed therebetween. The first conductive line CL1, the second conductive line CL2, and the third conductive line CL3 may overlap each other.

Although in the foregoing embodiment each of the 2-1-th scan line S2_1 and the 2-2-th scan line S2_2 are described as having a triple-layer structure including the first conductive line CL1, the second conductive line CL2, and the third conductive line CL3, the present disclosure is not limited thereto. In another embodiment, each of the 2-1-th scan line S2_1 and the 2-2-th scan line S2_2 may be implemented as a single layer structure, a double layer structure, or a multi-layer structure including more than three layers.

In an embodiment, the first conductive layer CL1 of each of the 2-1-th and 2-2-th scan lines S2_1 and S2_2 may be provided in common to some of the pixels PXL disposed on the same pixel column with respect to the second direction (e.g., the Y-axis direction). For example, the first conductive layer CL1 of each of the 2-1-th and 2-2-th scan lines S2_1 and S2_2 of the pixel PXL may be provided in common to the pixels PXL disposed on the same pixel column with respect to the second direction (e.g., the Y-axis direction). For example, the pixels PXL1 that are disposed on the same pixel column with respect to the second direction (e.g., the Y-axis direction) may share the first conductive line CL1 of each of the 2-1-th and 2-2-th scan lines S2_1 and S2_2.

At least one of the 2-1-th scan line S2_1 and the 2-2-th scan line S2_2 may be connected with the first scan line S1 through a contact hole (or contact opening). For example, the 2-1-th scan line S2_1 may be electrically connected to the first scan line S1 through a contact hole that successively passes through at least one insulating layer (e.g., the buffer layer, the gate insulating layer, and the interlayer insulating layer). Hence, the first scan line S1 may be selectively supplied with a scan signal and a control signal from the 2-1-th scan line S2_1. For example, the second scan line S2 may be a signal line that is connected with the first scan line S1 and configured to transmit, along with the first scan line S1, a scan signal and a control signal to some components of each of the first to third pixel circuits SPXC1, SPXC2, and SPXC3 (e.g., the second and third transistors T2 and T3 of each of the first to third pixel circuits SPXC1, SPXC2, and SPXC3).

The initialization power line IPL may extend in the second direction (e.g., the Y-axis direction). The initialization power line IPL may be the j-th sensing line SENj described, for example, with reference to FIG. 4. The voltage of the initialization power supply may be applied to the initialization power line IPL. In an embodiment, the initialization power line IPL may correspond to the first conductive layer. The initialization power line IPL may be provided and/or formed on the same layer as that of the first to third data lines D1, D2, and D3, the first layer FL of the first power line PL1, the 2a-th power lines PL2a, and the first conductive line CL1 of each of the 2-1-th and 2-2-th scan lines S2_1 and S2_2.

The initialization power line IPL may be electrically connected to the third transistor T3 of the first pixel circuit SPXC1 by a first conductive pattern CP1, may be electrically connected to the third transistor T3 of the second pixel circuit SPXC2 by a second conductive pattern CP2, and may be electrically connected to the third transistor T3 of the third pixel circuit SPXC3 by the second conductive pattern CP2.

The first conductive pattern CP1 may correspond to the third conductive layer provided and/or formed on the interlayer insulating layer. The first conductive pattern CP1 may be provided and/or formed on the same layer as that of the first scan line S1.

A first end of the first conductive pattern CP1 may be connected with the initialization power line IPL through a contact hole (or contact opening). For example, the first end of the first conductive line CP1 may be electrically connected with the initialization power line IPL through a contact hole that successively passes through the buffer layer, the gate insulating layer, and the interlayer insulating layer.

A second end of the first conductive pattern CP1 may be connected with the third transistor T3 of the first pixel circuit SPXC1 through another contact hole (or contact opening). For example, the second end of the first conductive pattern CP1 may be electrically connected with a third drain area DE3 of the third transistor T3 of the first pixel circuit SPXC1 through a contact hole that successively passes through the gate insulating layer and the interlayer insulating layer.

The second conductive pattern CP2 may correspond to the third conductive layer provided and/or formed on the interlayer insulating layer. The second conductive pattern CP2 may be provided and/or formed on the same layer as that of the first conductive pattern CP1.

The second conductive pattern CP2 may be connected with the initialization power line IPL through a contact hole (or contact opening). For example, the second conductive pattern CP2 may be electrically connected with the initialization power line IPL through a contact hole that successively passes through the buffer layer, the gate insulating layer, and the interlayer insulating layer.

The second conductive pattern CP2 may be connected with the third transistor T3 of the second pixel circuit SPXC2 through another contact hole (or contact opening). For example, the second conductive pattern CP2 may be electrically connected with a third drain area DE3 of the third transistor T3 of the second pixel circuit SPXC2 through a contact hole that successively passes through the gate insulating layer and the interlayer insulating layer.

The second conductive pattern CP2 may be connected with the third transistor T3 of the third pixel circuit SPXC3 through another contact hole (or contact opening). For example, the second conductive pattern CP2 may be electrically connected with a third drain area DE3 of the third transistor T3 of the third pixel circuit SPXC3 through a contact hole that successively passes through the gate insulating layer and the interlayer insulating layer.

The first power line PL1, the second power line PL2, the initialization power line IPL, the sub-scan line SS1, the first scan line S1, and the second scan line S2 may be components provided in common in the first to third pixel circuits SPXC1, SPXC2, and SPXC3.

Each of the first to third pixel circuits SPXC1, SPXC2, and SPXC3 may include a first transistor T1, a second transistor T2, a third transistor T3, and a storage capacitor. For example, the first pixel circuit SPXC1 may include first to third transistors T1, T2, and T3 and a first storage capacitor Cst1. The second pixel circuit SPXC2 may include first to third transistors T1, T2, and T3 and a second storage capacitor Cst2. The third pixel circuit SPXC3 may include first to third transistors T1, T2, and T3 and a third storage capacitor Cst3.

The first transistor T1 of each of the first to third pixel circuits SPXC1, SPXC2, and SPXC3 may correspond to the first transistor T1 described, as an example, with reference to FIG. 4. The second transistor T2 of each of the first to third pixel circuits SPXC1, SPXC2, and SPXC3 may correspond to the second transistor T2 described, as an example, with reference to FIG. 4. The third transistor T3 of each of the first to third pixel circuits SPXC1, SPXC2, and SPXC3 may correspond to the third transistor T3 described, as an example, with reference to FIG. 4.

The first to third pixel circuits SPXC1, SPXC2, and SPXC3 may have a substantially similar or identical structure. Hereinafter, the first pixel circuit SPXC1 from among the first to third pixel circuits SPXC1, SPXC2, and SPXC3 will be described as a representative example, and descriptions of the second and third pixel circuits SPXC2 and SPXC3 will be simplified.

The first pixel circuit SPXC1 may include a first transistor T1, a second transistor T2, a third transistor T3, and a first storage capacitor Cst1.

The first transistor T1 may include a first gate electrode GE1, a first active pattern ACT1, a first source area SE1, and a first drain area DE1.

The first gate electrode GE1 may be electrically connected to a second source area SE2 of the second transistor T2 by a third conductive pattern CP3. The first gate electrode GE1 may correspond to the second conductive layer provided and/or formed on the gate insulating layer. The first gate electrode GE1 may be provided and/or formed on the same layer as that of the sub-scan line SS1.

The third conductive pattern CP3 may correspond to the third conductive layer. A first end of the third conductive pattern CP3 may be connected with the first gate electrode GE1 through a contact hole (or contact opening). For example, the first end of the third conductive pattern CP3 may be electrically connected with the first gate electrode GE1 through a contact hole that passes through the interlayer insulating layer. A second end of the third conductive pattern CP3 may be connected with the second source area SE2 through another contact hole (or contact opening). For example, the second end of the third conductive pattern CP3 may be electrically connected with the second source area SE2 through a contact hole that successively passes through the gate insulating layer and the interlayer insulating layer.

The first active pattern ACT1, the first source area SE1, and the first drain area DE1 may each be a semiconductor pattern formed of poly silicon, amorphous silicon, an oxide semiconductor, or the like. Each of the first active pattern ACT1, the first source area SE1, and the first drain area DE1 may be formed of an undoped semiconductor layer or a semiconductor layer doped with an impurity. For example, each of the first source area SE1 and the first drain area DE1 may be formed of a semiconductor layer doped with an impurity. The first active pattern ACT1 may be formed of an undoped semiconductor layer.

The first active pattern ACT1, the first source area SE1, and the first drain area DE1 may be provided and/or formed on the buffer layer.

The first active pattern ACT1 may be a channel area of the first transistor T1 as an area overlapping the first gate electrode GE1. In an embodiment in which the first active pattern ACT1 is relatively long, the channel area of the first transistor T1 may also be relatively long. In such an embodiment, a driving range of a certain voltage (or a certain signal) to be applied to the first transistor T1 may be increased. Consequently, the gray scale of light emitted from the light emitting elements LD may be more precisely controlled.

The first source area SE1 may be connected to (brought into contact with) a first end of the first active pattern ACT1. Furthermore, the first source area SE1 may be electrically connected to a first bottom metal layer BML1 through a contact hole (or contact opening) that passes through the buffer layer.

The first bottom metal layer BML1 may correspond to the first conductive layer. The first bottom metal layer BML1 may be provided and/or formed on the same layer as that of the first to third data lines D1, D2, and D3, the first layer FL of the first power line PL1, the 2a-th power line PL2a, the first conductive line CL1 of each of the 2-1-th and 2-2-th scan lines S2_1 and S2_2, and the initialization power line IPL. The first bottom metal layer BML1 may be electrically connected to the first source area SE1 through a contact hole (or contact opening). When the first bottom metal layer BML1 is connected to the first transistor T1, a swing width margin of the second driving power supply VSS may be further increased. In such an embodiment, a driving range of a certain voltage to be applied to the first gate electrode GE1 of the first transistor T1 may be increased.

The first drain area DE1 may be connected to (or brought into contact with) a second end of the first active pattern ACT1. Furthermore, the first drain area DE1 may be connected with the first power line PL1 through a contact hole (or contact opening). For example, the first drain area DE1 may be electrically connected with the first layer FL of the first power line PL1 through a contact hole that passes through the buffer layer.

The second transistor T2 may include a second gate electrode GE2, a second active pattern ACT2, a second source area SE2, and a second drain area DE2.

The second gate electrode GE2 may be integrally provided with the sub-scan line SS1. In such an embodiment, the second gate electrode GE2 may correspond to one area of the sub-scan line SS1. As described above, because the sub-scan line SS1 is electrically connected with the first scan line S1 through a contact hole (or contact opening), a certain signal (e.g., a scan signal) applied to the first scan line S1 may be ultimately supplied to the second gate electrode GE2.

The second active pattern ACT2, the second source area SE2, and the second drain area DE2 each may be a semiconductor pattern formed of poly silicon, amorphous silicon, an oxide semiconductor, or the like. Each of the second active pattern ACT2, the second source area SE2, and the second drain area DE2 may be formed of an undoped semiconductor layer or a semiconductor layer doped with an impurity. For example, each of the second source area SE2 and the second drain area DE2 may be formed of a semiconductor layer doped with an impurity. The second active pattern ACT2 may be formed of an undoped semiconductor layer. The second active pattern ACT2, the second source area SE2, and the second drain area DE2 may be provided and/or formed on the buffer layer.

The second active pattern ACT2 may be a channel area of the second transistor T2 as an area overlapping the second gate electrode GE2.

The second source area SE2 may be connected to (brought into contact with) a first end of the second active pattern ACT2. Furthermore, the second source area SE2 may be connected to the first gate electrode GE1 by the third conductive pattern CP3.

The second drain area DE2 may be connected to (or brought into contact with) a second end of the second active pattern ACT2. Furthermore, the second drain area DE2 may be connected to the first data line D1 by a fourth conductive pattern CP4.

The fourth conductive pattern CP4 may correspond to the third conductive layer provided and/or formed on the interlayer insulating layer. A first end of the fourth conductive pattern CP4 may be electrically connected with the first data line D1 through a contact hole (or contact opening) that successively passes through the buffer layer, the gate insulating layer, and the interlayer insulating layer. A second end of the fourth conductive pattern CP4 may be connected to the second drain area DE2 through a contact hole (or contact opening) that successively passes through the gate insulating layer and the interlayer insulating layer. The second drain area DE2 and the first data line D1 may be electrically connected to each other by the fourth conductive pattern CP4.

The third transistor T3 may include a third gate electrode GE3, a third active pattern ACT3, a third source area SE3, and a third drain area DE3.

The third gate electrode GE3 may be integrally provided with the sub-scan line SS1. In such an embodiment, the third gate electrode GE3 may correspond to another area of the sub-scan line SS1. As described above, because the sub-scan line SS1 is connected with the first scan line S1 through the corresponding contact hole, a certain signal (e.g., a control signal) applied to the first scan line S1 may be ultimately supplied to the third gate electrode GE3.

The third active pattern ACT3, the third source area SE3, and the third drain area DE3 each may be a semiconductor pattern formed of poly silicon, amorphous silicon, an oxide semiconductor, or the like. Each of the third active pattern ACT3, the third source area SE3, and the third drain area DE3 may be formed of an undoped semiconductor layer or a semiconductor layer doped with an impurity. For example, each of the third source area SE3 and the third drain area DE3 may be formed of a semiconductor layer doped with an impurity. The third active pattern ACT3 may be formed of an undoped semiconductor layer.

The third active pattern ACT3, the third source area SE3, and the third drain area DE3 may be provided and/or formed on the buffer layer.

The third active pattern ACT3 may correspond to a channel area of the third transistor T3 as an area overlapping the third gate electrode GE3.

The third source area SE3 may be connected to (brought into contact with) a first end of the third active pattern ACT3. Furthermore, the third source area SE3 may be electrically connected to the first bottom metal layer BML1 through a contact hole (or contact opening) that passes through the buffer layer.

The third drain area DE3 may be connected to (or brought into contact with) a second end of the third active pattern ACT3. Furthermore, the third drain area DE3 may be electrically connected to the initialization power line IPL by the first conductive pattern CP1.

The first storage capacitor Cst1 may include a first lower electrode LE1 and a first upper electrode UE1. In some embodiments, the first storage capacitor Cst1 may be the storage capacitor Cst described with reference to FIG. 4.

The first lower electrode LE1 may be integrally provided with the first gate electrode GE1. In such an embodiment, the first lower electrode LE1 may be one area of the first gate electrode GE1.

The first upper electrode UE1 may be disposed to overlap the first lower electrode LE1 in a plan view and may have a size (or a surface area) greater than that of the first lower electrode LE1, but the present disclosure is not limited thereto. In a plan view, the first upper electrode UE1 may overlap each of the first source area SE1 and the third source area SE3. The first upper electrode UE1 may correspond to the third conductive layer provided and/or formed on the interlayer insulating layer.

The first upper electrode UE1 may be electrically connected to the first bottom metal layer BML1 through a contact hole (or contact opening) that successively passes through the buffer layer, the gate insulating layer, and an interlayer insulating layer. As described above, because the first source area SE1 and the third source area SE3 are electrically connected with the first bottom metal layer BML1, the first upper electrode UE1 may be electrically connected with the first and third source areas SE1 and SE3 via the first bottom metal layer BML1.

The first pixel circuit SPXC1 may be electrically connected to the first emission component EMU1. For example, the first emission component EMU1 may be electrically connected to the first upper electrode UE1 of the first storage capacitor Cst1 through a first contact hole (e.g., a first contact opening) CNT1.

The second pixel circuit SPXC2 may include a first transistor T1, a second transistor T2, a third transistor T3, and a second storage capacitor Cst2.

The first transistor T1 may include a first gate electrode GE1, a first active pattern ACT1, a first source area SE1, and a first drain area DE1.

The first gate electrode GE1 may be connected to a second source area SE2 of the second transistor T2.

The first active pattern ACT1 may be a channel area of the first transistor T1.

The first source electrode SE1 may be connected to the first active pattern ACT1. Furthermore, the first source area SE1 may be electrically connected to a second bottom metal layer BML2 through a contact hole (or contact opening) that passes through the buffer layer.

The second bottom metal layer BML2 may be a component corresponding to the first bottom metal layer BML1. The second bottom metal layer BML2 may correspond to the first conductive layer. The second bottom metal layer BML2 may be electrically connected to the first source area SE1 through a contact hole (or contact opening). Furthermore, the second bottom metal layer BML2 may be electrically connected to the third source area SE3 of the third transistor T3 through another contact hole (or contact opening) that passes through the buffer layer. In addition, the second bottom metal layer BML2 may be electrically connected to the second upper electrode UE2 through another contact hole (or contact opening) that successively passes through the buffer layer, the gate insulating layer, and the interlayer insulating layer.

The first drain area DE1 may be connected to the first active pattern ACT1. Furthermore, the first drain area DE1 may be electrically connected to the first layer FL of the first power line PL1 through another contact hole (or contact opening) that passes through the buffer layer.

The second transistor T2 may include a second gate electrode GE2, a second active pattern ACT2, a second source area SE2, and a second drain area DE2.

The second gate electrode GE2 may be integrally provided with the sub-scan line SS1 and may be connected with the first scan line S1.

The second active pattern ACT2 may be a channel area of the second transistor T2.

The second source electrode SE2 may be connected to the second active pattern ACT2. Furthermore, the second source area SE2 may be connected to the first gate electrode GE1 by a fifth conductive pattern CP5.

The fifth conductive pattern CP5 may correspond to the third conductive layer provided and/or formed on the interlayer insulating layer. A first end of the fifth conductive pattern CP5 may be electrically connected to the second source area SE2 through a contact hole (or contact opening) that successively passes through the gate insulating layer and the interlayer insulating layer. A second end of the fifth conductive pattern CP5 may be connected to the first gate electrode GE1 through a contact hole (or contact opening) that passes through the interlayer insulating layer.

The second drain area DE2 may be connected to the second active pattern ACT2. Furthermore, the second drain area DE2 may be connected to the second data line D2 by a sixth conductive pattern CP6.

The sixth conductive pattern CP6 may correspond to the third conductive layer provided and/or formed on the interlayer insulating layer. A first end of the sixth conductive pattern CP6 may be electrically connected to the second data line D2 through a contact hole (or contact opening) that successively passes through the buffer layer, the gate insulating layer, and the interlayer insulating layer. A second end of the sixth conductive pattern CP6 may be electrically connected to the second drain area DE2 through a contact hole (or contact opening) that successively passes through the gate insulating layer and the interlayer insulating layer.

The third transistor T3 may include a third gate electrode GE3, a third active pattern ACT3, a third source area SE3, and a third drain area DE3.

The third gate electrode GE3 may be integrally provided with the sub-scan line SS1 and may be connected with the first scan line S1.

The third active pattern ACT3 may be a channel area of the third transistor T3.

The third source electrode SE3 may be electrically connected to the third active pattern ACT3. Furthermore, the third source area SE3 may be electrically connected to a second bottom metal layer BML2 through a contact hole (or contact opening).

The third drain area DE3 may be connected to the third active pattern ACT3. Furthermore, the third drain area DE3 may be connected to the initialization power line IPL via the second conductive pattern CP2.

The second storage capacitor Cst2 may have a structure substantially equal or similar to that of the first storage capacitor Cst1 of the first pixel circuit SPXC1. For example, the second storage capacitor Cst2 may include a second lower electrode LE2 and a second upper electrode UE2.

The second lower electrode LE2 may correspond to the second conductive layer and may be integrally provided with the second gate electrode GE2 of the second transistor T2. The second upper electrode UE2 may correspond to the third conductive layer and may overlap the second lower electrode LE2. The second upper electrode UE2 may be electrically connected to a second bottom metal layer BML2 through a contact hole (or contact opening).

As described above, the second upper electrode UE2 may be electrically connected to each of the first source area SE1 and the third source area SE3 via the second bottom metal layer BML2.

The second pixel circuit SPXC2 may be electrically connected to the second emission component EMU2. For example, the second emission component EMU2 may be electrically connected to the second pixel circuit SPXC2 through a second contact hole (e.g., a second contact opening) CNT2.

The third pixel circuit SPXC3 may include a first transistor T1, a second transistor T2, a third transistor T3, and a third storage capacitor Cst3.

The first transistor T1 may include a first gate electrode GE1, a first active pattern ACT1, a first source area SE1, and a first drain area DE1.

The first gate electrode GE1 may be connected to a second source area SE2 of the third transistor T3.

The first active pattern ACT1 may be a channel area of the first transistor T1.

The first source electrode SE1 may be connected to the first active pattern ACT1. Furthermore, the first source area SE1 may be electrically connected to a third bottom metal layer BML3 through a contact hole (or contact opening) that passes through the buffer layer.

The third bottom metal layer BML3 may be a component corresponding to each of the first and second bottom metal layers BML1 and BML2. The third bottom metal layer BML3 may correspond to the first conductive layer. The third bottom metal layer BML3 may be electrically connected to the first source area SE1 through a contact hole (or contact opening). Furthermore, the third bottom metal layer BML3 may be electrically connected to the third source area SE3 of the third transistor T3 through another contact hole (or contact opening) that passes through the buffer layer. In addition, the third bottom metal layer BML3 may be electrically connected to the third upper electrode UE3 through another contact hole (or contact opening) that successively passes through the buffer layer, the gate insulating layer, and the interlayer insulating layer.

The first drain area DE1 may be connected to the first active pattern ACT1. Furthermore, the first drain area DE1 may be electrically connected to the first layer FL of the first power line PL1 through another contact hole (or contact opening) that passes through the buffer layer.

The second transistor T2 may include a second gate electrode GE2, a second active pattern ACT2, a second source area SE2, and a second drain area DE2.

The second gate electrode GE2 may be integrally provided with the sub-scan line SS1 and may be connected with the first scan line S1.

The second active pattern ACT2 may be a channel area of the second transistor T2.

The second source electrode SE2 may be connected to the second active pattern ACT2. Furthermore, the second source area SE2 may be electrically connected to the third bottom metal layer BML3 through a contact hole (or contact opening).

The second drain area DE2 may be connected to the second active pattern ACT2. Furthermore, the second drain area DE2 may be connected to the third data electrode D3 by a seventh conductive pattern CP7.

The seventh conductive pattern CP7 may correspond to the third conductive layer provided and/or formed on the interlayer insulating layer. A first end of the seventh conductive pattern CP7 may be electrically connected to the third data line D3 through a contact hole (or contact opening) that successively passes through the buffer layer, the gate insulating layer, and the interlayer insulating layer. A second end of the seventh conductive pattern CP7 may be electrically connected to the second drain area DE2 through a contact hole (or contact opening) that successively passes through the gate insulating layer and the interlayer insulating layer. Hence, the second drain area DE2 and the third data line D3 may be connected to each other via the seventh conductive pattern CP7.

The third transistor T3 may include a third gate electrode GE3, a third active pattern ACT3, a third source area SE3, and a third drain area DE3.

The third gate electrode GE3 may be integrally provided with the sub-scan line SS1 and may be connected with the first scan line S1.

The third active pattern ACT3 may be a channel area of the third transistor T3.

The third source electrode SE3 may be connected to the third active pattern ACT3. Furthermore, the third source area SE3 may be connected to the first gate electrode GE1 via an eighth conductive pattern CP8.

The eighth conductive pattern CP8 may correspond to the third conductive layer provided and/or formed on the interlayer insulating layer. A first end of the eighth conductive pattern CP8 may be electrically connected to the third source area SE3 through a contact hole (or contact opening) that successively passes through the gate insulating layer and the interlayer insulating layer. A second end of the eighth conductive pattern CP8 may be connected to the first gate electrode GE1 through a contact hole (or contact opening) that passes through the interlayer insulating layer. Hence, the first gate electrode GE1 and the third source area SE3 may be connected to each other via the eighth conductive pattern CP8.

The third drain area DE3 may be connected to the third active pattern ACT3. Furthermore, the third drain area DE3 may be connected to the initialization power line IPL via the eighth conductive pattern CP8. In an embodiment, the third drain area DE3 of the third transistor T3 and the third drain area DE3 of the second transistor T2 may share the eighth conductive pattern CP8.

The third storage capacitor Cst3 may have a structure substantially equal or similar to that of each of the first and second storage capacitors Cst1 and Cst2. For example, the third storage capacitor Cst3 may include a third lower electrode LE3 and a third upper electrode UE3.

The third lower electrode LE3 may correspond to the second conductive layer and may be integrally provided with the first gate electrode GE1 of the corresponding transistor (e.g., the third transistor T3). The third upper electrode UE3 may correspond to the third conductive layer and may overlap the third lower electrode LE3. The third upper electrode UE3 may be electrically connected to the third bottom metal layer BML3 through a contact hole (or contact opening). As described above, the third upper electrode UE3 may be electrically connected to each of the first source area SE1 and the third source area SE3 via the third bottom metal layer BML3.

The third pixel circuit SPXC3 may be electrically connected to the third emission component EMU3. For example, the third emission component EMU3 may be electrically connected to the third pixel circuit SPXC3 through a third contact hole (e.g., a third contact opening) CNT3.

The buffer layer may be disposed between the first conductive layer and the active patterns ACT1, ACT2, and ACT3. The buffer layer may prevent impurities or the like from diffusing into each of the first to third pixel circuits SPXC1, SPXC2, and SPXC3. The buffer layer may be formed of a single layer or multiple layers and may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The gate insulating layer may be disposed between the active patterns ACT1, ACT2, and ACT3 and the second conductive layer. The gate insulating layer may be formed of a single layer or multiple layers and may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The interlayer insulating layer may be disposed between the second conductive layer and the third conductive layer. The interlayer insulating layer may be formed of a single layer or multiple layers and may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The passivation layer and the via layer may be disposed on the third conductive layer. The passivation layer may be formed of a single layer or multiple layers and may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The via layer may be disposed on the passivation layer. The via layer may be formed of organic material to planarize a stepped structure formed thereunder. For example, the via layer may include organic material, such as acrylic resin, epoxy resin, phenolic resin, polyamide resin, polyimide resin, polyester resin, polyphenylene sulfide resin, or benzocyclobutene (BCB). However, the present disclosure is not limited thereto, and the via layer may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), or titanium oxide (TiOₓ).

Hereinafter, the emission area EMA of the pixel PXL will be described in detail based on FIG. 6. The pixel area PXA may include a first emission area EMA1, a second emission area EMA2, and a third emission area EMA3. The first emission area EMA1, the second emission area EMA2, and the third emission area EMA3 may form the emission area EMA of the pixel PXL.

The first emission component EMU1 disposed in the first emission area EMA1 may be electrically connected to the first pixel circuit SPXC1. For example, the first emission area EMA1 may be an area where light is emitted from the light emitting elements LD that are driven by the first pixel circuit SPXC1. In an embodiment, the first emission area EMA1 may be an emission area of the first sub-pixel SPXL1.

The second emission component EMU2 disposed in the second emission area EMA2 may be electrically connected to the second pixel circuit SPXC2. The second emission area EMA2 may be an area where light is emitted from the light emitting elements LD that are driven by the second pixel circuit SPXC2. In an embodiment, the second emission area EMA2 may be an emission area of the second sub-pixel SPXL2.

The third emission component EMU3 disposed in the third emission area EMA3 may be electrically connected to the third pixel circuit SPXC3. The third emission area EMA3 may be an area where light is emitted from the light emitting elements LD that are driven by the third pixel circuit SPXC3. In an embodiment, the third emission area EMA3 may be an emission area of the third sub-pixel SPXL3.

For example, the first emission area EMA1, the second emission area EMA2, and the third emission area EMA3 may be partitioned from each other in the first direction (e.g., the X-axis direction). For example, the second emission component EMU2 may be disposed between the first emission component EMU1 and the third emission component EMU3.

The pixel area PXA may include a non-emission area NEA that is adjacent to the first emission area EMA1 (or encloses or extends around the perimeter or periphery of the first emission area EMA1), a non-emission area NEA that is adjacent to the second emission area EMA2 (or encloses or extends around the perimeter or periphery of the second emission area EMA2), and a non-emission area NEA that is adjacent to the third emission area EMA3 (or encloses or extends around the perimeter or periphery of the third emission area EMA3).

A bank BNK may be disposed in the non-emission area NEA. The bank BNK may be a structure that encloses the respective first to third emission areas EMA1, EMA2, and EMA3 of the first to third sub-pixels SPXL1, SPXL2, and SPXL3, and may be, for example, a pixel defining layer. The bank BNK may be disposed in an area between the first to third emission areas EMA1, EMA2, and EMA3 and around the perimeters (or peripheries) of the first to third emission areas EMA1, EMA2, and EMA3.

The bank BNK may also act as a dam structure to define each emission area EMA to which the light emitting elements LD are to be supplied during a process of supplying the light emitting elements LD to the pixel PXL. For example, because the first to third emission areas EMA1, EMA2, and EMA3 are partitioned by the bank BNK, a mixed solution including a target amount and/or type of light emitting elements LD may be input (or deposited) to each of the first to third emission areas EMA1, EMA2, and EMA3.

The bank BNK may include, in the pixel area PXA, opening areas which expose components disposed thereunder. In an embodiment, the first to third emission areas EMA1, EMA2, and EMA3 may be respectively defined by the opening areas of the bank BNK. The first to third emission areas EMA1, EMA2, and EMA3 may respectively correspond to the opening areas in the bank BNK.

Because the bank BNK is disposed in the non-emission area NEA between the first to third emission areas EMA1, EMA2, and EMA3, a supply (or input) area of the pixel area PXA to which light emitting elements LD are to be supplied (or input or deposited) may be determined. Hence, at the step of supplying light emitting elements LD to the pixel PXL, the light emitting elements LD may not be supplied to undesired areas, and the light emitting elements LD may be efficiently supplied to each of the first to third emission areas EMA1, EMA2, and EMA3. Therefore, the light emitting elements LD may not be unnecessarily wasted, and the manufacturing cost of the display device may be reduced.

First to third electrodes ALE1, ALE2, and ALE3 may be disposed in each of the first to third emission areas EMA1, EMA2, and EMA3 (or the first to third sub-pixel areas SPXA1, SPXA2, and SPXA3).

The first to third electrodes ALE1, ALE2, and ALE3 may each extend in the second direction (e.g., the Y-axis direction) and may be spaced apart from each other in the first direction (e.g., the X-axis direction). For example, the first to third electrodes ALE1, ALE2, and ALE3 of the first emission area EMA1 (or the first sub-pixel area SPXA1) may be successively arranged in the first direction (e.g., the X-axis direction). Furthermore, the first to third electrodes ALE1, ALE2, and ALE3 of the second emission area EMA2 (or the second sub-pixel area SPXA2) may be successively arranged in a direction opposite to the first direction. In addition, the first to third electrodes ALE1, ALE2, and ALE3 of the third emission area EMA3 (or the third sub-pixel area SPXA3) may be successively arranged in the first direction (e.g., the X-axis direction).

The first to third electrodes ALE1, ALE2, and ALE3 may each receive a certain alignment signal before the light emitting elements LD are aligned in the emission area EMA of the pixel PXL and, thus, may be used as an electrode (or an alignment line) for aligning the light emitting elements LD.

At the step of aligning the light emitting elements, the first electrode ALE1 may receive a first alignment signal, the second electrode ALE2 may receive a second alignment signal, and the third electrode ALE3 may receive a first alignment signal. The first and second alignment signals may be signals having a voltage difference and/or a phase difference causing the light emitting elements LD to be aligned between the first to third electrodes ALE1, ALE2, and ALE3. At least one of the first and second alignment signals may be an AC (alternating current) signal, but the present disclosure is not limited thereto.

After the light emitting elements LD are aligned in each of the first to third emission areas EMA1, EMA2, and EMA3, a portion of each of the first to third electrodes ALE1, ALE2, and ALE3 disposed between the sub-pixels SPXL that are adjacent to each other in the second direction (e.g., the Y-axis direction) may be removed, but the present disclosure is not limited thereto.

In an embodiment, bank patterns BNP may be disposed under the electrodes ALE. The bank patterns BNP may be provided in at least the emission area EMA. The bank patterns BNP may extend in the second direction (e.g., the Y-axis direction) and may be spaced apart from each other in the first direction (e.g., the X-axis direction).

Because the bank patterns BNP are provided under respective partial areas of the electrodes ALE, the respective partial areas of the electrodes ALE may protrude upwardly in a third direction (e.g., a Z-axis direction) in the areas where the respective patterns BNP are formed. When the bank patterns BNP and/or the electrodes ALE include reflective material, a reflective wall structure may be formed around the light emitting elements LD. Hence, light emitted from the light emitting elements LD may be emitted in an upward direction of the pixel PXL (e.g., in a frontal direction of the display panel PNL including a certain viewing angle range) improving the light output efficiency of the display panel PNL.

Hereinafter, configurations of the sub-pixel SPXL will be described in detail based on FIG. 7. For the sake of convenience, repetitive explanation of the same configuration as that described above may be omitted.

Each sub-pixel SPXL may include light emitting elements LD, connection electrodes ELT, and/or sub-electrodes SLT. For example, the sub-pixel SPXL shown in FIG. 7 may be any one of the first to third sub-pixels SPXL1, SPXL2, and SPXL3 that form the pixel PXL shown in FIG. 3, and the first to third sub-pixels SPXL1, SPXL2, and SPXL3 may have substantially identical or similar structures. Although FIG. 7 illustrates an embodiment in which each sub-pixel SPXL includes light emitting elements LD disposed in four serial stages as illustrated in FIG. 4, the number of serial stages in each sub-pixel SPXL may be modified or changed depending on embodiments.

Hereinafter, the term "light emitting element LD" or "light emitting elements LD" will be used to arbitrarily designate at least one light emitting element of the first to fourth light emitting elements LD1, LD2, LD3, and LD4 or to collectively designate two or more kinds of light emitting elements. Furthermore, the term "connection electrode ELT" or "connection electrodes ELT" will be used to arbitrarily designate at least one electrode of the electrodes including the first to fifth connection electrodes ELT1, ELT2, ELT3, ELT4, and ELT5. Furthermore, the term "sub-electrode SLT" or "sub-electrodes SLT" will be used to arbitrarily designate at least one electrode of the electrodes including the first to fourth sub-electrodes SLT1, SLT2, SLT3, and SLT4.

The light emitting elements LD may be aligned between the above-mentioned electrodes ALE in each emission area EMA. Furthermore, the light emitting elements LD each may be electrically connected between a pair of connection electrodes ELT.

The first light emitting element LD1 may be aligned between the first and second electrodes ALE1 and ALE2. The first light emitting element LD1 may be electrically connected between the first and second connection electrodes ELT1 and ELT2. For example, the first light emitting element LD1 may be aligned in first areas (e.g., upper end areas) of the first and second electrodes ALE1 and ALE2. The first end EP1 of the first light emitting element LD1 may be electrically connected to the first connection electrode ELT1. The second end EP2 of the first light emitting element LD1 may be electrically connected to the second connection electrode ELT2.

The second light emitting element LD2 may be aligned between the first and second electrodes ALE1 and ALE2. The second light emitting element LD2 may be electrically connected between the second and third connection electrodes ELT2 and ELT3. For example, the second light emitting element LD2 may be aligned in second areas (e.g., lower end areas) of the first and second electrodes ALE1 and ALE2. The first end EP1 of the second light emitting element LD2 may be electrically connected to the second connection electrode ELT2. The second end EP2 of the second light emitting element LD2 may be electrically connected to the third connection electrode ELT3.

The third light emitting element LD3 may be aligned between the second and third electrodes ALE2 and ALE3. The third light emitting element LD3 may be electrically connected between the third and fourth connection electrodes ELT3 and ELT4. For example, the third light emitting element LD3 may be aligned in second areas (e.g., lower end areas) of the second and third electrodes ALE2 and ALE3. The first end EP1 of the third light emitting element LD3 may be electrically connected to the third connection electrode ELT3. The second end EP2 of the third light emitting element LD3 may be electrically connected to the fourth connection electrode ELT4.

The fourth light emitting element LD4 may be aligned between the second and third electrodes ALE2 and ALE3. The fourth light emitting element LD4 may be electrically connected between the fourth and fifth connection electrodes ELT4 and ELT5. For example, the fourth light emitting element LD4 may be aligned in first areas (e.g., upper end areas) of the second and third electrodes ALE2 and ALE3. The first end EP1 of the fourth light emitting element LD4 may be electrically connected to the fourth connection electrode ELT4. The second end EP2 of the fourth light emitting element LD4 may be electrically connected to the fifth connection electrode ELT5.

For example, the first light emitting element LD1 may be disposed in a left upper end area of the emission area EMA. The second light emitting element LD2 may be disposed in a left lower end area of the emission area EMA. The third light emitting element LD3 may be disposed in a right lower end area of the emission area EMA. The fourth light emitting element LD4 may be disposed in a right upper end area of the emission area EMA. The arrangement and/or connection structure of the light emitting elements LD may be changed in various ways depending on the structure of the emission component EMU and/or the number of serial stages.

The connection electrodes ELT may each be provided in at least the emission area EMA and may be disposed to overlap at least one electrode ALE and/or light emitting element LD. For example, the connection electrodes ELT may be provided on the electrodes ALE and/or the light emitting elements LD such that each of the connection electrodes ELT overlaps the corresponding electrodes ALE and/or the corresponding light emitting elements LD, whereby the connection electrodes ELT may be electrically connected to the light emitting elements LD.

The first connection electrode ELT1 may be disposed on the first area (e.g., the upper end area) of the second electrode ALE2 and the first ends EP1 of the first light emitting elements LD1 and, thus, may be electrically connected to the first ends EP1 of the first light emitting elements LD1.

The second connection electrode ELT2 may be disposed on the first area (e.g., the upper end area) of the first electrode ALE1 and the second ends EP2 of the first light emitting elements LD1 and, thus, may be electrically connected to the second ends EP2 of the first light emitting elements LD1. Furthermore, the second connection electrode ELT2 maybe disposed on the second area (e.g., the lower end area) of the second electrode ALE2 and the first ends EP1 of the second light emitting elements LD2 and, thus, may be electrically connected to the first ends EP1 of the second light emitting elements LD2. For example, the second connection electrode ELT2 may electrically connect the second ends EP2 of the first light emitting elements LD1 and the first ends EP1 of the second light emitting elements LD2 to each other in the emission area EMA. To this end, the second connection electrode ELT2 may have a bent shape. For example, the second connection electrode ELT2 may have a bent or curved structure (or shape) at a boundary between an area where at least one first light emitting element LD1 is disposed and an area where at least one second light emitting element LD2 is disposed.

The third connection electrode ELT3 may be disposed on the second area (e.g., the lower end area) of the first electrode ALE1 and the second ends EP2 of the second light emitting elements LD2 and, thus, may be electrically connected to the second ends EP2 of the second light emitting elements LD2. Furthermore, the third connection electrode ELT3 may be disposed on the second area (e.g., the lower end area) of the second electrode ALE2 and the first ends EP1 of the third light emitting elements LD3 and, thus, may be electrically connected to the first ends EP1 of the third light emitting elements LD3. For example, the third connection electrode ELT3 may electrically connect the second ends EP2 of the second light emitting elements LD2 and the first ends EP1 of the third light emitting elements LD3 to each other in the emission area EMA. To this end, the third connection electrode ELT3 may have a bent shape. For example, the third connection electrode ELT3 may have a bent or curved structure (or shape) at a boundary between an area where at least one second light emitting element LD2 is disposed and an area where at least one third light emitting element LD3 is disposed.

The fourth connection electrode ELT4 may be disposed on the second area (e.g., the lower end area) of the third electrode ALE3 and the second ends EP2 of the third light emitting elements LD3 and, thus, may be electrically connected to the second ends EP2 of the third light emitting elements LD3. Furthermore, the fourth connection electrode ELT4 may be disposed on the first area (e.g., the upper end area) of the second electrode ALE2 and the first ends EP1 of the fourth light emitting elements LD4 and, thus, may be electrically connected to the first ends EP1 of the fourth light emitting elements LD4. For example, the fourth connection electrode ELT4 may electrically connect the second ends EP2 of the third light emitting elements LD3 and the first ends EP1 of the fourth light emitting elements LD4 to each other in the emission area EMA. To this end, the fourth connection electrode ELT4 may have a bent shape. For example, the fourth connection electrode ELT4 may have a bent or curved structure (or shape) at a boundary between an area where at least one third light emitting element LD3 is disposed and an area where at least one fourth light emitting element LD4 is disposed.

The fifth connection electrode ELT5 may be disposed on the first area (e.g., the upper end area) of the third electrode ALE3 and the second ends EP2 of the fourth light emitting elements LD4 and, thus, may be electrically connected to the second ends EP2 of the fourth light emitting elements LD4.

In this way, the light emitting elements LD aligned between the electrodes ALE may be connected in a desired form by using the connection electrodes ELT. For example, the first light emitting elements LD1, the second light emitting elements LD2, the third light emitting elements LD3, and the fourth light emitting elements LD4 may be successively connected in series by using the connection electrodes ELT.

The sub-electrodes SLT may be respectively electrically connected to the connection electrodes ELT. For example, the first sub-electrode SLT1 may be electrically connected to the second connection electrode ELT2. The second sub-electrode SLT2 may be electrically connected to the third connection electrode ELT3. The third sub-electrode SLT3 may be electrically connected to the fourth connection electrode ELT4. The fourth sub-electrode SLT4 may be electrically connected to the fifth connection electrode ELT5.

The first sub-electrode SLT1 may be integrally provided with the second connection electrode ELT2. The second sub-electrode SLT2 may be integrally provided with the third connection electrode ELT3. The third sub-electrode SLT3 may be integrally provided with the fourth connection electrode ELT4. The fourth sub-electrode SLT4 may be integrally provided with the fifth connection electrode ELT5. However, the present disclosure is not limited thereto.

The sub-electrodes SLT may be spaced apart from the connection electrodes ELT. The sub-electrodes SLT and the connection electrodes ELT may be respectively electrically connected to each other by connectors CN1 and CN2. For example, a first end of each of the sub-electrodes SLT may be electrically connected to a corresponding one of the connection electrodes ELT by the first connector CN1. A second end of each of the sub-electrodes SLT may be electrically connected to a corresponding one of the connection electrodes ELT by the second connector CN2. For example, the first connector CN1 and/or the second connector CN2 may be integrally provided with the sub-electrodes SLT and/or the connection electrodes ELT and may be disposed on the same layer as that of the sub-electrodes SLT and/or the connection electrodes ELT, but the present disclosure is not limited thereto.

The sub-electrodes SLT may extend in the second direction (e.g., the Y-axis direction) and may be spaced apart from the connection electrodes ELT in the first direction (e.g., the X-axis direction). The first connector CN1 and/or the second connector CN2 may extend in the first direction (e.g., the X-axis direction) between the sub-electrodes SLT and the connection electrodes ELT. As such, when the sub-electrodes SLT are electrically connected with the connection electrodes ELT, a dark spot defect of the sub-pixel SPXL may be mitigated.

Hereinafter, a connection relationship between the sub-electrodes SLT of the sub-pixel SPXL will be described in detail based on FIG. 8. For the sake of convenience, repetitive explanation of the same configuration as that described above may be omitted.

At least one of the sub-electrodes SLT of the sub-pixel SPXL may be electrically connected with at least one of the sub-electrodes SLT of an adjacent sub-pixel SPXL. For example, the fourth sub-electrode SLT4 of the first sub-pixel SPXL1 may be electrically connected to the fourth sub-electrode SLT4 of the second sub-pixel SPXL2.

At least one of the sub-electrodes SLT of the sub-pixel SPXL may be electrically connected with at least one of the sub-electrodes SLT of an adjacent sub-pixel SPXL by an intermediate electrode IE. The intermediate electrode IE may be disposed at a boundary between adjacent sub-pixels SPXL or in a space therebetween and connected to at least one of the sub-electrodes SLT of each of the adjacent sub-pixels SPXL. For example, the intermediate electrode IE may be integrally provided with at least one of the sub-electrodes SLT of the sub-pixels SPXL and disposed on the same layer as that of the at least one, but the present disclosure is not limited thereto.

The fourth sub-electrode SLT4 of the first sub-pixel SPXL1 may be spaced apart from the fourth sub-electrode SLT4 of the second sub-pixel SPXL2. The fourth sub-electrode SLT4 of the first sub-pixel SPXL1 and the fourth sub-electrode SLT4 of the second sub-pixel SPXL2 may be electrically connected to each other by the intermediate electrode IE. The intermediate electrode IE may be integrally provided with the fourth sub-electrode SLT4 of the first sub-pixel SPXL1 and/or the fourth sub-electrode SLT4 of the second sub-pixel SPXL2 and disposed on a layer identical thereto, but the present disclosure is not limited thereto.

Although FIG. 8 illustrates an embodiment in which the sub-electrodes SLT of the third sub-pixel SPXL3 are separated from the sub-electrodes SLT of the first sub-pixel SPXL1 and/or the sub-electrodes SLT of the second sub-pixel SPXL2, the present disclosure is not limited thereto. In an embodiment, at least one of the sub-electrodes SLT of the third sub-pixel SPXL3 may be electrically connected to at least one of the sub-electrodes SLT of the first sub-pixel SPXL1 and/or the sub-electrodes SLT of the second sub-pixel SPXL2.

At least one of the connection electrodes ELT of each of the sub-pixels SPXL may be electrically connected to a corresponding one of the pixel circuits SPXC through the corresponding contact hole CNT1, CNT2, or CNT3. For example, the first connection electrode ELT1 of the first sub-pixel SPXL1 may be electrically connected to the first pixel circuit SPXC1 through the first contact hole CNT1. The first connection electrode ELT1 of the second sub-pixel SPXL2 may be electrically connected to the second pixel circuit SPXC2 through the second contact hole CNT2. The first connection electrode ELT1 of the third sub-pixel SPXL3 may be electrically connected to the third pixel circuit SPXC3 through the third contact hole CNT3.

Hereinafter, a connection relationship between the sub-electrodes SLT of the sub-pixel SPXL and a power connection line PCL will be described in detail based on FIG. 9. For the sake of convenience, repetitive explanation of the same configuration as that described above will be omitted.

At least one of the sub-electrodes SLT of each of the sub-pixels SPXL may be electrically connected with the power connection line PCL. The power connection line PCL may be electrically connected with the above-described second power line PL2 through a contact hole (e.g., a contact opening) CNT so that the voltage of the second driving power supply VSS may be applied to the power connection line PCL.

The respective fourth sub-electrodes SLT4 of the sub-pixels SPXL may be electrically connected with the power connection line PCL. The power connection line PCL may extend in the first direction (e.g., the X-axis direction) between the sub-pixels SPXL provided on different rows. The fourth sub-electrodes SLT4 of the sub-pixels SPXL each may extend in the second direction (e.g., the Y-axis direction). Hence, the power connection line PCL and the fourth sub-electrodes SLT4 of the sub-pixels SPXL each may have a mesh structure. The fourth sub-electrode SLT4 of the first sub-pixel SPXL1 may extend in the second direction (e.g., the Y-axis direction) and may be electrically connected with the power connection line PCL that is provided on an upper side thereof. The fourth sub-electrode SLT4 of the second sub-pixel SPXL2 may extend in the second direction (e.g., the Y-axis direction) and may be electrically connected with the power connection line PCL that is provided on a lower side thereof. The fourth sub-electrode SLT4 of the third sub-pixel SPXL3 may extend in the second direction (the Y-axis direction) and may be electrically connected with the power connection line PCL that is provided on the upper side. However, the connection relationship between the sub-electrodes SLT of each of the sub-pixels SPXL and the power connection line PCL is not limited thereto. The connection structure between the sub-electrodes SLT and the power connection line PCL may be changed in various ways as long as the sub-electrodes SLT and the power connection line PCL form a mesh structure.

As described above, when the sub-electrodes SLT of adjacent sub-pixels SPXL are connected to each other and connected with the power connection line PCL to form a mesh structure, the number of contacts on the power connection lines PCL may be reduced so that design space in the display device having a high resolution can be secured, a risk of resistance increase can be reduced, and electrostatic discharge can be improved.

Hereinafter, a cross-sectional structure of the sub-pixel SPXL will be described, in detail, based on the light emitting element LD shown in FIG. 10. FIG. 10 illustrates a light emitting element layer LEL of the sub-pixel SPXL.

Referring to FIG. 10, the sub-pixel SPXL in accordance with an embodiment may include bank patterns BNP, electrodes ALE, light emitting elements LD, connection electrodes ELT, and/or sub-electrodes SLT that are disposed on the substrate SUB. Because the substrate SUB has been described above with reference to FIGS. 3 to 5, a repetitive explanation thereof will be omitted.

The bank patterns BNP may be disposed on the substrate SUB. Depending on embodiments, the bank patterns BNP may have various shapes. In an embodiment, the bank patterns BNP may each have a shape protruding from the substrate SUB in the third direction (e.g., the Z-axis direction). Furthermore, the bank patterns BNP each may have an inclined surface that is inclined at a certain angle with respect to the substrate SUB. However, the present disclosure is not limited thereto. The bank patterns BNP each may have a sidewall having a curved or stepped shape. For example, the bank patterns BNP may each have a cross-sectional shape, such as a semi-circular or semi-elliptical shape.

The electrodes and the insulating layers that are disposed over the bank patterns BNP may have shapes corresponding to that of the bank patterns BNP. For example, the electrodes ALE that are disposed on the bank patterns BNP may have inclined surfaces or curved surfaces having shapes corresponding to that of the bank patterns BNP. Hence, the bank patterns BNP along with the electrodes ALE provided thereon may act as reflectors and guide light emitted from the light emitting elements LD in the frontal direction of the pixel PXL in the third direction DR3 (e.g., the Z-axis direction), thus, enhancing the light output efficiency of the display panel PNL.

The bank patterns BNP may include at least one organic material and/or inorganic material. For example, the bank patterns BNP may include organic material, such as acrylic resin, epoxy resin, phenolic resin, polyamide resin, polyimide resin, polyester resin, polyphenylene sulfide resin, or benzocyclobutene (BCB). However, the present disclosure is not limited thereto. The bank patterns BNP may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), or titanium oxide (TiOₓ).

The electrodes ALE may be disposed on the bank patterns BNP. The electrodes ALE may be disposed at positions spaced apart from each other in the sub-pixel SPXL. The electrodes ALE may be disposed on the same layer. For example, the electrodes ALE may be concurrently (or simultaneously) formed through the same process, but the present disclosure is not limited thereto.

The electrodes ALE may be supplied with alignment signals at the step of aligning the light emitting elements LD. Therefore, an electric field may be formed between the electrodes ALE so that the light emitting elements LD provided in each of the sub-pixels SPXL may be aligned between the electrodes ALE.

The electrodes ALE may include at least one conductive material. For example, the electrodes ALE each may include at least one material from among at least one metal of various metal materials, such as silver (Ag), magnesium (Mg), aluminum (Al), platinum (Pt), palladium (Pd), gold (Au), nickel (Ni), neodymium (Nd), iridium (Ir), chrome (Cr), titanium (Ti), molybdenum (Mo), copper (Cu), etc., or an alloy thereof, a conductive oxide, such as indium tin oxide (ITO), indium zinc oxide (IZO), indium tin zinc oxide (ITZO), aluminum zinc oxide (AZO), gallium zinc oxide (GZO), zinc tin oxide (ZTO), or gallium tin oxide (GTO), and a conductive polymer, such as PEDOT, but the present disclosure is not limited thereto.

A first insulating layer INS1 may be disposed on the electrodes ALE. The first insulating layer INS1 may be formed of a single layer or multiple layers and may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The bank BNK may be disposed on the first insulating layer INS1. The bank BNK may form, at the step of supplying the light emitting elements LD to each of the sub-pixels SPXL, a dam structure to define an emission area to which the light emitting elements LD are to be supplied. For example, a desired kind and/or amount of light emitting element ink may be supplied to the area defined by the bank BNK.

The bank BNK may include organic material, such as acrylic resin, epoxy resin, phenolic resin, polyamide resin, polyimide resin, polyester resin, polyphenylene sulfide resin, or benzocyclobutene (BCB). However, the present disclosure is not limited thereto. The bank BNK may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), or titanium oxide (TiOₓ).

In an embodiment, the bank BNK may include at least one light shielding and/or reflective material. Therefore, light leakage between adjacent sub-pixels SPXL may be prevented. For example, the bank BNK may include at least one black matrix material and/or color filter material. For instance, the bank BNK may be formed of a black opaque pattern that can block the transmission of light. In an embodiment, a reflective layer or the like may be formed on a surface (e.g., a sidewall) of the bank BNK to increase the light efficiency of each sub-pixel SPXL.

The light emitting elements LD may be disposed on the first insulating layer INS1. The light emitting elements LD may be disposed on the first insulating layer INS1 between the electrodes ALE. The light emitting elements LD may be prepared in a diffused form in the light emitting element ink and then supplied to each of the sub-pixels SPXL by an inkjet printing scheme (or method) or the like. For example, the light emitting elements LD may be diffused in a volatile solvent and supplied to each of the sub-pixels SPXL. Thereafter, when alignment signals are supplied to the electrodes ALE, an electric field may be formed between the electrodes ALE causing the light emitting elements LD to be aligned between the electrodes ALE. After the light emitting elements LD have been aligned, the solvent may be removed (or evaporated) by a volatilization scheme or other schemes. Thus, the light emitting elements LD may be reliably arranged and aligned between the electrodes ALE.

A second insulating layer INS2 may be disposed on the light emitting elements LD. For example, the second insulating layer INS2 may be partially provided on the light emitting elements LD so that the first and second ends EP1 and EP2 of the light emitting elements LD are exposed from the second insulating layer INS2. In an embodiment in which the second insulating layer INS2 is formed on the light emitting elements LD after the alignment of the light emitting elements LD has been completed, the light emitting elements LD may not be removed (or shifted) from the aligned positions.

The second insulating layer INS2 may be formed of a single layer or multiple layers and may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The connection electrodes ELT may be disposed on the first and second ends EP1 and EP2 of the light emitting elements LD that are exposed from the second insulating layer INS2.

The first connection electrode ELT1 may be directly disposed on the first ends EP1 of the first light emitting elements LD1 and may contact the first ends EP1 of the first light emitting elements LD1.

Furthermore, the second connection electrode ELT2 may be directly disposed on the second ends EP2 of the first light emitting elements LD1 and may contact the second ends EP2 of the first light emitting elements LD1. Furthermore, the second connection electrode ELT2 may be directly disposed on the first ends EP1 of the second light emitting elements LD2 and may contact the first ends EP1 of the second light emitting elements LD2. For example, the second connection electrode ELT2 may electrically connect the second ends EP2 of the first light emitting elements LD1 with the first ends EP1 of the second light emitting elements LD2.

Similarly, the third connection electrode ELT3 may be directly disposed on the second ends EP2 of the second light emitting elements LD2 and may contact the second ends EP2 of the second light emitting elements LD2. Furthermore, the third connection electrode ELT3 may be directly disposed on the first ends EP1 of the third light emitting elements LD3 and may contact the first ends EP1 of the third light emitting elements LD3. For example, the third connection electrode ELT3 may electrically connect the second ends EP2 of the second light emitting elements LD2 with the first ends EP1 of the third light emitting elements LD3.

Similarly, the fourth connection electrode ELT4 may be directly disposed on the second ends EP2 of the third light emitting elements LD3 and may contact the second ends EP2 of the third light emitting elements LD3. Furthermore, the fourth connection electrode ELT4 may be directly disposed on the first ends EP1 of the fourth light emitting elements LD4 and may contact the first ends EP1 of the fourth light emitting elements LD4. For example, the fourth connection electrode ELT4 may electrically connect the second ends EP2 of the third light emitting elements LD3 with the first ends EP1 of the fourth light emitting elements LD4.

Similarly, the fifth connection electrode ELT5 may be directly disposed on the second ends EP2 of the fourth light emitting elements LD4 and may contact the second ends EP2 of the fourth light emitting elements LD4.

The connection electrodes ELT may be formed of a plurality of conductive layers. For example, the first connection electrode ELT1, the third connection electrode ELT3, and/or the fifth connection electrode ELT5 may be formed of an identical conductive layer (e.g., the same conductive layer). For example, the first connection electrode ELT1, the third connection electrode ELT3, and/or the fifth connection electrode ELT5 may be concurrently (or simultaneously) formed through the same process. Furthermore, the second connection electrode ELT2 and/or the fourth connection electrode ELT4 may be formed of an identical conductive layer (e.g., the same conductive layer). For example, the second connection electrode ELT2 and/or the fourth connection electrode ELT4 may be concurrently (or simultaneously) formed through the same process. For instance, the third insulating layer INS3 may be disposed on the second connection electrode ELT2 and/or the fourth connection electrode ELT4. The first connection electrode ELT1, the third connection electrode ELT3, and/or the fifth connection electrode ELT5 may be disposed on the third insulating layer INS3. The third insulating layer INS3 may be formed of a single layer or multiple layers and may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

As described above, in an embodiment in which the third insulating layer INS3 is disposed between the connection electrodes ELT that are formed of a plurality of conductive layers, the connection electrodes ELT may be reliably separated from each other by the third insulating layer INS3 so that electrical stability between the first and second ends EP1 and EP2 of the light emitting elements LD can be secured.

The connection electrodes ELT each may be formed of various transparent conductive materials. For example, the connection electrodes ELT may each include at least one of various transparent conductive materials including indium tin oxide (ITO), indium zinc oxide (IZO), indium tin zinc oxide (ITZO), aluminum zinc oxide (AZO), gallium zinc oxide (GZO), zinc tin oxide (ZTO), or gallium tin oxide (GTO) and may be substantially transparent or translucent to provide satisfactory transmittance. Hence, light emitted from the first and second ends EP1 and EP2 of the light emitting elements LD may pass through the connection electrodes ELT and to be emitted outside the display panel PNL.

The sub-electrodes SLT may be disposed on the same layer as that of the respective connection electrodes ELT. For example, the sub-electrodes SLT and the connection electrodes ELT that are electrically connected to each other, and the connectors CN1 and CN2 that connect the sub-electrodes SLT and the connection electrodes ELT, may be integrally provided with each other and disposed on the same layer.

For example, the first sub-electrode SLT1 may be disposed on the same layer as that of the second connection electrode ELT2. For example, the first sub-electrode SLT1 and the second connection electrode ELT2 may be concurrently (or simultaneously) formed through the same process, but the present disclosure is not limited thereto. Furthermore, the second sub-electrode SLT2 may be disposed on the same layer as that of the third connection electrode ELT3. For example, the second sub-electrode SLT2 and the third connection electrode ELT3 may be concurrently (or simultaneously) formed through the same process, but the present disclosure is not limited thereto. Furthermore, the third sub-electrode SLT3 may be disposed on the same layer as that of the fourth connection electrode ELT4. For example, the third sub-electrode SLT3 and the fourth connection electrode ELT4 may be concurrently (or simultaneously) formed through the same process, but the present disclosure is not limited thereto. Furthermore, the fourth sub-electrode SLT4 may be disposed on the same layer as that of the fifth connection electrode ELT5. For example, the fourth sub-electrode SLT4 and the fifth connection electrode ELT5 may be concurrently (or simultaneously) formed through the same process, but the present disclosure is not limited thereto.

FIG. 11 illustrates a partition wall WL, a color conversion layer CCL, an optical layer OPL, a color filter layer CFL, and/or an overcoat layer OC that are provided on the light emitting element layer LEL of the sub-pixel SPXL described above with reference to FIG. 10.

Referring to FIG. 11, the partition wall WL may be disposed on the light emitting element layer LEL for the first to third sub-pixels SPXL1, SPXL2, and SPXL3. For example, the partition wall WL may be disposed between the first to third sub-pixels SPXL1, SPXL2, and SPXL3 or at boundaries therebetween and may include openings that respectively overlap the first to third sub-pixels SPXL1, SPXL2, and SPXL3. The openings in the partition wall WL may provide space in which the color conversion layer CCL can be provided.

The partition wall WL may include organic material, such as acrylic resin, epoxy resin, phenolic resin, polyamide resin, polyimide resin, polyester resin, polyphenylene sulfide resin, or benzocyclobutene (BCB). However, the present disclosure is not limited thereto. The partition wall WL may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

In an embodiment, the partition wall WL may include at least one light shielding and/or reflective material. Therefore, light leakage between adjacent sub-pixels SPXL may be prevented. For example, the partition wall WL may include at least one black matrix material and/or color filter material. For instance, the partition wall WL may be formed of a black opaque pattern that can block transmission of light. In an embodiment, a reflective layer or the like may be formed on a surface (e.g., a sidewall) of the partition wall WL to increase the light efficiency of each sub-pixel SPXL.

The color conversion layer CCL may be disposed on the light emitting element layer LEL including the light emitting elements LD in the openings of the partition wall WL. The color conversion layer CCL may include a first color conversion layer CCL1 disposed in the first sub-pixel SPXL1, a second color conversion layer CCL2 disposed in the second sub-pixel SPXL2, and a light scattering layer LSL disposed in the third sub-pixel SPXL3.

In an embodiment, the first to third sub-pixels SPXL1, SPXL2, and SPXL3 may include light emitting elements LD configured to emit the same color of light. For example, the first to third sub-pixels SPXL1, SPXL2, and SPXL3 may include light emitting elements LD configured to emit the third color of light (e.g., blue light). Because the color conversion layer CCL including color conversion particles is disposed in each of the first to third sub-pixels SPXL1, SPXL2, and SPXL3, a full-color image may be displayed.

The first color conversion layer CCL₁ may include first color conversion particles for converting the third color of light emitted from the light emitting element LD to the first color of light. For example, the first color conversion layer CCL₁ may include a plurality of first quantum dots QD₁ dispersed in a matrix material, such as base resin.

In an embodiment in which the light emitting element LD is a blue light emitting element configured to emit blue light and the first sub-pixel SPXL₁ is a red pixel, the first color conversion layer CCL₁ may include the first quantum dots QD₁ that may convert blue light emitted from the blue light emitting element to red light. The first quantum dots QD₁ may absorb blue light, shift the wavelength thereof according to an energy transition, and thus, emit red light. When the first sub-pixel SPXL₁ is one of pixels of (or configured to emit) other colors, the first color conversion layer CCL₁ may include the first quantum dots QD₁ corresponding to the color of the first sub-pixel SPXL₁.

The second color conversion layer CCL₂ may include second color conversion particles for converting the third color of light emitted from the light emitting element LD to the second color of light. For example, the second color conversion layer CCL₂ may include a plurality of second quantum dots QD₂ dispersed in a matrix material, such as base resin.

In an embodiment in which the light emitting element LD is a blue light emitting element configured to emit blue light and the second sub-pixel SPXL₂ is a green pixel, the second color conversion layer CCL₂ may include the second quantum dots QD₂ that may convert blue light emitted from the blue light emitting element to green light. The second quantum dots QD₂ may absorb blue light, shift the wavelength thereof according to an energy transition, and thus, emit green light. When the second sub-pixel SPXL₂ is one of pixels of (or configured to emit) other colors, the second color conversion layer CCL₂ may include the second quantum dots QD₂ corresponding to the color of the second sub-pixel SPXL₂.

Because blue light having a relatively short wavelength in a visible ray area is incident on each of the first quantum dots QD₁ and the second quantum dots QD₂, absorption coefficients of the first quantum dot QD₁ and the second quantum dot QD₂ may be increased. Therefore, the efficiency of light emitted from the first sub-pixel SPXL₁ and the second sub-pixel SPXL₂ may be enhanced and satisfactory color reproducibility may be secured. Furthermore, because the emission circuit EMU for the first to third sub-pixels SPXL₁, SPXL₂, and SPXL₃ is formed of light emitting elements LD (e.g., blue light emitting elements) configured to emit the same color of light, the efficiency of fabricating the display device may be enhanced.

The light scattering layer LSL may be provided to efficiently use the third color of light (or blue light) emitted from the light emitting element LD. For example, in an embodiment in which the light emitting element LD is a blue light emitting element configured to emit blue light and the third sub-pixel SPXL₃ is a blue pixel, the light scattering layer LSL may include at least one type of light scatterer SCT to efficiently use (or emit) light emitted from the light emitting element LD.

For example, the light scattering layer LSL may include a plurality of light scatterer SCT dispersed in a matrix material, such as base resin. For instance, the light scattering layer LSL may include a light scatterer SCT formed of material such as silica, but the constituent material of the light scatterer SCT is not limited thereto. The light scatterers SCT may be provided not only in the third sub-pixel SPXL₃ but may also be selectively included in the first conversion layer CCL₁ or the second color conversion layer CCL₂. In an embodiment, the light scatterers SCT may be omitted, and the light scattering layer LSL may be formed of transparent polymer.

A first capping layer CPL1 may be disposed on the color conversion layer CCL. The first capping layer CPL1 may be provided over the first to third sub-pixels SPXL1, SPXL2, and SPXL₃. The first capping layer CPL₁ may cover the color conversion layer CCL. The first capping layer CPL₁ may prevent the color conversion layer CCL from being damaged or contaminated by permeation of external impurities, such as water or air.

The first capping layer CPL₁ may be an inorganic layer and may be formed of silicon nitride (SiNₓ), aluminum nitride (AlNₓ), titanium nitride (TiNₓ), silicon oxide (SiOₓ), aluminum oxide (AlOₓ), titanium oxide (TiOₓ), silicon oxycarbide (SiOₓC_{y}), or silicon oxynitride (SiOₓN_{y}).

The optical layer OPL may be disposed on the first capping layer CPL1. The optical layer OPL may recycle light provided from the color conversion layer CCL by total reflection and, thus, may enhance light extraction efficiency. Hence, the optical layer OPL may have a relatively low refractive index compared to that of the color conversion layer CCL. For example, the refractive index of the color conversion layer CCL may be in a range from about 1.6 to about 2.0, and the refractive index of the optical layer OPL may be in a range from about 1.1 to about 1.3.

A second capping layer CPL2 may be disposed on the optical layer OPL. The second capping layer CPL2 may be provided over the first to third sub-pixels SPXL1, SPXL2, and SPXL₃. The second capping layer CPL2 may cover the optical layer OPL. The second capping layer CPL₂ may prevent the optical layer OPL from being damaged or contaminated by permeation of external impurities, such as water or air.

The second capping layer CPL2 may be an inorganic layer and may be formed of silicon nitride (SiNₓ), aluminum nitride (AlNₓ), titanium nitride (TiNₓ), silicon oxide (SiOₓ), aluminum oxide (AlOₓ), titanium oxide (TiOₓ), silicon oxycarbide (SiOₓC_{y}), or silicon oxynitride (SiOₓN_{y}).

A planarization layer PLL may be disposed on the second capping layer CPL₂. The planarization layer PLL may be provided over the first to third sub-pixels SPXL1, SPXL2, and SPXL₃.

The planarization layer PLL may include organic material, such as acrylic resin, epoxy resin, phenolic resin, polyamide resin, polyimide resin, polyester resin, polyphenylene sulfide resin, or benzocyclobutene (BCB). However, the present disclosure is not limited thereto. The planarization layer PLL may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

The color filter layer CFL may be disposed on the planarization layer PLL. The color filter layer CFL may include color filters CF₁, CF₂, and CF₃ corresponding to the colors of the respective pixels PXL. The color filters CF₁, CF₂, and CF₃ corresponding to the respective colors of the first to third sub-pixels SPXL₁, SPXL₂, and SPXL₃ may allow for a full-color image to be displayed.

The color filter layer CFL may include a first color filter CF₁ disposed in the first sub-pixel SPXL₁ and configured to allow light emitted from the first sub-pixel SPXL₁ to selectively pass therethrough, a second color filter CF₂ disposed in the second sub-pixel SPXL₂ and configured to allow light emitted from the second sub-pixel SPXL₂ to selectively pass therethrough, and a third color filter CF₃ disposed in the third sub-pixel SPXL₃ and configured to allow light emitted from the third sub-pixel SPXL₃ to selectively pass therethrough.

In an embodiment, the first color filter CF₁, the second color filter CF₂, and the third color filter CF₃ may be respectively a red color filter, a green color filter, and a blue color filter, but the present disclosure is not limited thereto. Hereinafter, the term "color filter CF" or "color filters CF" will be used to designate any color filter from among the first color filter CF₁, the second color filter CF₂, and the third color filter CF₃ or to collectively designate two or more kinds of color filters.

The first color filter CF₁ may overlap the light emitting element layer LEL (or the light emitting elements LD) of the first sub-pixel SPXL₁ and the first color conversion layer CCL₁ in the third direction (e.g., the Z-axis direction). The first color filter CF₁ may include color filter material allowing the first color of light (or red light) to selectively pass therethrough. For example, when the first sub-pixel SPXL₁ is a red pixel, the first color filter CF₁ may include red color filter material.

The second color filter CF₂ may overlap the light emitting element layer LEL (or the light emitting elements LD) of the second sub-pixel SPXL₂ and the second color conversion layer CCL₂ in the third direction (e.g., the Z-axis direction). The second color filter CF₂ may include color filter material allowing the second color of light (or green light) to selectively pass therethrough. For example, when the second sub-pixel SPXL₂ is a green pixel, the second color filter CF₂ may include green color filter material.

The third color filter CF₃ may overlap the light emitting element layer LEL (or the light emitting elements LD) of the third sub-pixel SPXL₃ and the light scattering layer LSL in the third direction (e.g., the Z-axis direction). The third color filter CF₃ may include color filter material allowing the third color of light (or blue light) to selectively pass therethrough. For example, when the third sub-pixel SPXL₃ is a blue pixel, the third color filter CF₃ may include blue color filter material.

A light shielding layer BM may be disposed between the first to third color filters CF₁, CF₂, and CF₃. The light shielding layer BM may be disposed between the first to third sub-pixels SPXL₁, SPXL₂, and SPXL₃ or at boundaries therebetween. The material of the light shielding layer BM is not particularly limited. Various light shielding materials, including black matrix material, may be used to form the light shielding layer BM. When the light shielding layer BM is formed between the first to third color filters CF₁, CF₂, and CF₃, a color mixing defect, which is visible from a front surface or side surface of the display device, may be prevented.

An overcoat layer OC may be disposed on the color filter layer CFL. The overcoat layer OC may be provided over the first to third sub-pixels SPXL₁, SPXL₂, and SPXL₃. The overcoat layer OC may cover a lower component including the color filter layer CFL. The overcoat layer OC may prevent water or air from permeating to the lower component. Furthermore, the overcoat layer OC may protect the lower component from foreign material, such as dust.

The overcoat layer OC may include organic material, such as acrylic resin, epoxy resin, phenolic resin, polyamide resin, polyimide resin, polyester resin, polyphenylene sulfide resin, or benzocyclobutene (BCB). However, the present disclosure is not limited thereto. The overcoat layer OC may include various inorganic materials including silicon oxide (SiOₓ), silicon nitride (SiNₓ), silicon oxynitride (SiOₓN_{y}), aluminum nitride (AlNₓ), aluminum oxide (AlOₓ), zirconium oxide (ZrOₓ), hafnium oxide (HfOₓ), and titanium oxide (TiOₓ).

In accordance with the foregoing embodiments, the sub-electrodes SLT of adjacent sub-pixels SPXL may be connected to each other and connected to the power connection line PCL to form a mesh structure so that a dark spot defect of the sub-pixels SPXL can be mitigated and a high-resolution display device can be more easily embodied.

Hereinafter, another embodiment will be described. In descriptions of the following embodiment, like reference numerals will be used to designate the above-described configurations and the same components, and redundant explanation thereof may be omitted or simplified.

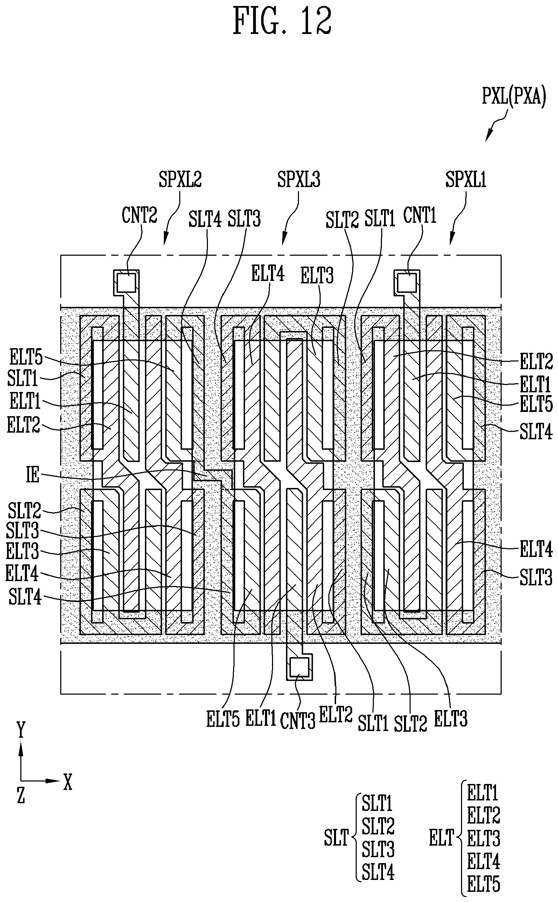

FIG. 12 is a plan view showing a connection relationship between sub-electrodes SLT of sub-pixels SPXL in accordance with an embodiment.

Referring to FIG. 12, at least one of the sub-electrodes SLT of the sub-pixel SPXL may be electrically connected with at least one of the sub-electrodes SLT of an adj acent sub-pixel SPXL. For example, the fourth sub-electrode SLT₄ of the second sub-pixel SPXL₂ may be electrically connected to the fourth sub-electrode SLT₄ of the third sub-pixel SPXL₃.

At least one of the sub-electrodes SLT of the sub-pixel SPXL may be electrically connected with at least one of the sub-electrodes SLT of an adjacent sub-pixel SPXL by an intermediate electrode IE. The intermediate electrode IE may be disposed at a boundary between adjacent sub-pixels SPXL or in space therebetween and connected to at least one of the sub-electrodes SLT of each of the adjacent sub-pixels SPXL. For example, the intermediate electrode IE may be integrally provided with at least one of the sub-electrodes SLT of the sub-pixels SPXL and disposed on the same layer as that of the at least one sub-electrodes SLT, but the present disclosure is not limited thereto. For instance, the fourth sub-electrode SLT₄ of the second sub-pixel SPXL₂ may be spaced apart from the fourth sub-electrode SLT₄ of the third sub-pixel SPXL₃. The fourth sub-electrode SLT₄ of the second sub-pixel SPXL₂ and the fourth sub-electrode SLT₄ of the third sub-pixel SPXL₃ may be electrically connected to each other by the intermediate electrode IE. The intermediate electrode IE may be integrally provided with the fourth sub-electrode SLT₄ of the second sub-pixel SPXL₂ and/or the fourth sub-electrode SLT₄ of the third sub-pixel SPXL₃, but the present disclosure is not limited thereto.

Although FIG. 12 illustrates an embodiment in which the sub-electrodes SLT of the first sub-pixel SPXL₁ are separated from the sub-electrodes SLT of the second sub-pixel SPXL₂ and/or the sub-electrodes SLT of the third sub-pixel SPXL₃, the present disclosure is not limited thereto. In another embodiment, at least one of the sub-electrodes SLT of the first sub-pixel SPXL₁ may be electrically connected to at least one of the sub-electrodes SLT of the second sub-pixel SPXL₂ and/or the sub-electrodes SLT of the third sub-pixel SPXL₃. In this way, the sub-electrodes SLT of adjacent sub-pixels SPXL may be connected to each other and connected to the power connection line PCL to form a mesh structure so that a dark spot defect of the sub-pixels SPXL can be mitigated and a high-resolution display device can be easily embodied, as described above.

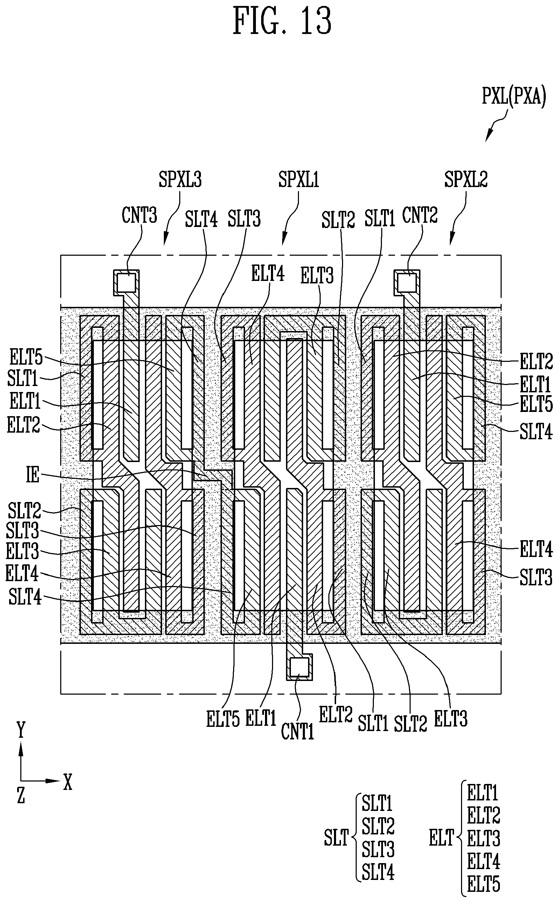

FIG. 13 is a plan view showing a connection relationship between sub-electrodes SLT of sub-pixels SPXL in accordance with an embodiment.

Referring to FIG. 13, at least one of the sub-electrodes SLT of the sub-pixel SPXL may be electrically connected with at least one of the sub-electrodes SLT of an adj acent sub-pixel SPXL. For example, the fourth sub-electrode SLT₄ of the third sub-pixel SPXL₃ may be electrically connected to the fourth sub-electrode SLT₄ of the first sub-pixel SPXL₁.

At least one of the sub-electrodes SLT of the sub-pixel SPXL may be electrically connected with at least one of the sub-electrodes SLT of an adjacent sub-pixel SPXL by an intermediate electrode IE. The intermediate electrode IE may be disposed at a boundary between adjacent sub-pixels SPXL or in space therebetween and connected to at least one of the sub-electrodes SLT of each of the adjacent sub-pixels SPXL. For example, the intermediate electrode IE may be integrally provided with at least one of the sub-electrodes SLT of the sub-pixels SPXL and disposed on the same layer as that of the at least one, but the present disclosure is not limited thereto. For example, the fourth sub-electrode SLT₄ of the third sub-pixel SPXL₃ may be spaced apart from the fourth sub-electrode SLT₄ of the first sub-pixel SPXL₁. The fourth sub-electrode SLT₄ of the third sub-pixel SPXL₃ and the fourth sub-electrode SLT₄ of the first sub-pixel SPXL₁ may be electrically connected to each other by the intermediate electrode IE. The intermediate electrode IE may be integrally provided with the fourth sub-electrode SLT₄ of the third sub-pixel SPXL₃ and/or the fourth sub-electrode SLT₄ of the first sub-pixel SPXL₁, but the present disclosure is not limited thereto.

Although FIG. 13 illustrates an embodiment in which the sub-electrodes SLT of the second sub-pixel SPXL₂ are separated from the sub-electrodes SLT of the first sub-pixel SPXL₁ and/or the sub-electrodes SLT of the third sub-pixel SPXL₃, the present disclosure is not limited thereto. In an embodiment, at least one of the sub-electrodes SLT of the second sub-pixel SPXL₂ may be electrically connected to at least one of the sub-electrodes SLT of the first sub-pixel SPXL₁ and/or the sub-electrodes SLT of the third sub-pixel SPXL₃.

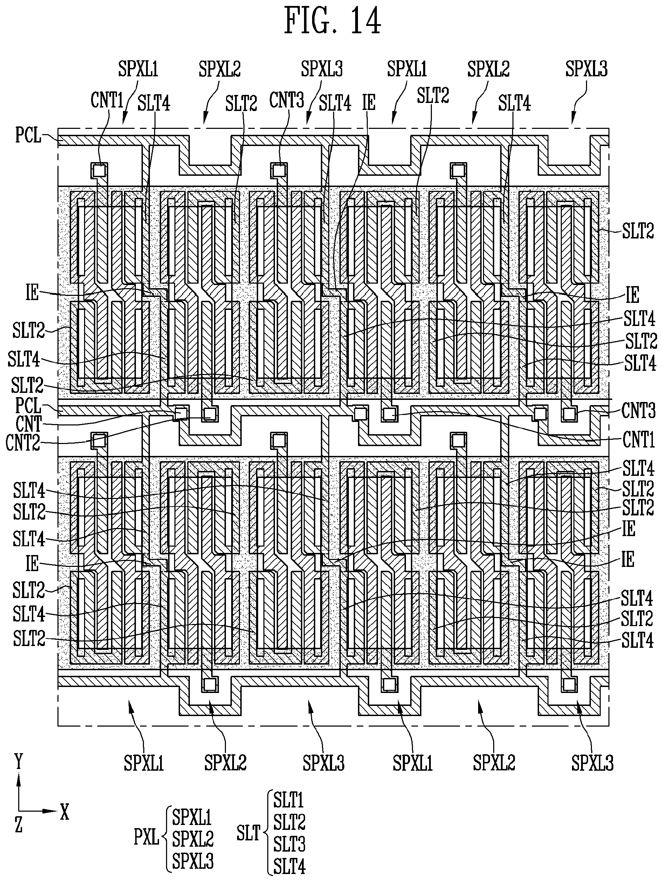

FIG. 14 is a plan view showing a connection relationship between sub-electrodes SLT of sub-pixels SPXL in accordance with an embodiment.

Referring to FIG. 14, fourth sub-electrodes SLT₄ of at least some first sub-pixels SPXL₁ may be electrically connected with fourth sub-electrodes SLT₄ of at least some second sub-pixels SPXL₂. The fourth sub-electrodes SLT₄ of the at least some first sub-pixels SPXL₁ may extend in the second direction (e.g., the Y-axis direction) and may be electrically connected to the power connection line PCL that is disposed on an upper side thereof. The fourth sub-electrodes SLT₄ of the at least some second sub-pixels SPXL₂ may extend in a direction opposite to the second direction and may be electrically connected to the power connection line PCL that is disposed on a lower side thereof.

Furthermore, fourth sub-electrodes SLT₄ of at least some third sub-pixels SPXL₃ may be electrically connected with fourth sub-electrodes SLT₄ of at least some first sub-pixels SPXL₁. The fourth sub-electrodes SLT₄ of the at least some third sub-pixels SPXL₃ may extend in the second direction (e.g., the Y-axis direction) and may be electrically connected to the power connection line PCL that is disposed on the upper side. The fourth sub-electrodes SLT₄ of the at least some first sub-pixels SPXL₁ may extend in the direction opposite to the second direction and may be electrically connected to the power connection line PCL that is disposed on the lower side.

Furthermore, fourth sub-electrodes SLT₄ of at least some second sub-pixels SPXL₂ may be electrically connected with fourth sub-electrodes SLT₄ of at least some third sub-pixels SPXL₃. The fourth sub-electrodes SLT₄ of the at least some second sub-pixels SPXL₂ may extend in the second direction (e.g., the Y-axis direction) and may be electrically connected to the power connection line PCL that is disposed on the upper side. The fourth sub-electrodes SLT₄ of the at least some third sub-pixels SPXL₃ may extend in the direction opposite to the second direction and may be electrically connected to the power connection line PCL that is disposed on the lower side.

As described above, because the fourth sub-electrodes SLT₄ of the sub-pixels SPXL are connected to the power connection line PCL, the respective fourth sub-electrodes SLT₄ of the sub-pixels SPXL may form a mesh structure. As such, when the sub-electrodes SLT of adjacent sub-pixels SPXL are connected to each other and connected with the power connection line PCL to form a mesh structure, the number of contacts on the power connection lines PCL may be reduced so that design space in the display device having a high resolution can be secured, resistance increase risk can be reduced, and electrostatic discharge can be improved, as described above.

In accordance with embodiments of the present disclosure, sub-electrodes of adjacent sub-pixels may be connected to each other and connected with a power connection line to form a mesh structure so that a dark spot defect of a pixel can be mitigated and a high-resolution display device can be easily embodied.

The aspects and features of the present disclosure are not limited by the foregoing, and other various aspects and features are anticipated herein.

It will be understood by those skilled in the art that various changes in form and details may be made to the embodiments described herein without departing from the scope of the present invention as defined by the appended claims. Therefore, the foregoing embodiments should be considered in a descriptive sense and not for purposes of limitation.

## Claims

1. A display device comprising first, second, and third pixels adjacent to each other, each of the first, second, and third pixels comprising:
light emitting elements (LD);
connection electrodes (ELT) electrically connected to ends of the light emitting elements; and
sub-electrodes (SLT) on the same layer as the connection electrodes and electrically connected to the connection electrodes,
wherein one of the sub-electrodes (SLT₄) of the first pixel is electrically connected to one of the sub-electrodes (SLT₄) of the second pixel.

2. The display device according to claim 1, wherein the sub-electrode of the first pixel and the sub-electrode of the second pixel that are electrically connected to each other are on the same layer.

3. The display device according to claim 1 or 2, further comprising an intermediate electrode (IE) connecting the sub-electrode of the first pixel and the sub-electrode of the second pixel that are electrically connected to each other.

4. The display device according to any one of the preceding claims, wherein the sub-electrodes of the third pixel are separated from the sub-electrodes of the first pixel and/or the sub-electrodes of the second pixel.

5. The display device according to any one of the preceding claims, wherein one of the sub-electrodes of the third pixel is electrically connected to one of the sub-electrodes of the first pixel.

6. The display device according to any one of the preceding claims, wherein the connection electrodes respectively comprise:
a first connection electrode electrically connected to a first end of each of the light emitting elements; and
a second connection electrode electrically connected to a second end of each of the light emitting elements,
wherein the first connection electrode and the second connection electrode are on different layers.

7. The display device according to claim 6, wherein the sub-electrodes respectively comprise:
a first sub-electrode on the same layer as the first connection electrode and electrically connected to the first connection electrode; and
a second sub-electrode on the same layer as the second connection electrode and electrically connected to the second connection electrode.

8. The display device according to claim 7, wherein the second sub-electrode of the first pixel is electrically connected to the second sub-electrode of the second pixel.

9. The display device according to any one of the preceding claims, further comprising:
a first color conversion layer in the first pixel;
a second color conversion layer in the second pixel; and
a light scattering layer in the third pixel.

10. The display device according to any one of the preceding claims, further comprising:
a first connector (CN₁) connecting first ends of the sub-electrodes to the respective connection electrodes; and
a second connector (CN₂) connecting second ends of the sub-electrodes to the respective connection electrodes.

11. The display device according to claim 10, wherein the first connector and/or the second connector extends in a first direction between the connection electrodes and the sub-electrodes.

12. The display device according to claim 11, wherein the sub-electrodes extend in a second direction crossing the first direction.

13. The display device according to claim 10, 11 or 12, wherein the sub-electrodes are on the same layer as the first connector and/or the second connector.

14. The display device according to any one of claims 10 to 13, wherein the first connector and the second connector are on the same layer.
